(19) Europäisches Patentamt
European Patent Office
Office européen des brevets

(11) EP 2 687 877 A1

(12) **EUROPEAN PATENT APPLICATION**
published in accordance with Art. 153(4) EPC

(43) Date of publication:
**22.01.2014 Bulletin 2014/04**

(21) Application number: **12756982.0**

(22) Date of filing: **14.03.2012**

(51) Int Cl.:
***G02B 3/08*** *(2006.01)* ***G02B 3/00*** *(2006.01)*
***H01L 31/052*** *(2006.01)*

(86) International application number:
**PCT/JP2012/056536**

(87) International publication number:
**WO 2012/124728 (20.09.2012 Gazette 2012/38)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **14.03.2011 JP 2011055787**

(71) Applicant: **Daikin Industries, Ltd.**
**Osaka-shi, Osaka 530-8323 (JP)**

(72) Inventors:
- **NAKAHARA Sumio**
**Suita-shi, Osaka 564-8680 (JP)**
- **SATOH Kazuyuki**
**Osaka 530-8323 (JP)**
- **SAGISAKA Shigehito**
**Osaka 530-8323 (JP)**

(74) Representative: **HOFFMANN EITLE**
**Patent- und Rechtsanwälte**
**Arabellastrasse 4**
**81925 München (DE)**

# (54) LIGHT-GATHERING FILM AND SOLAR BATTERY MODULE

(57) The present invention provides a light-concentrating film capable of concentrating incident light in a wide angular range with high efficiency and a solar cell module provided with the light-concentrating film.

The present invention relates to a light-concentrating film made of an organic material, the light-concentrating film having a repeating structure of fine concavo-convex on at least one surface, the height (H) of the concavo-convex being 0.1 to 100 μm, and the frequency (P) of the concavo-convex being 0.1 to 500 μm, the concavo-convex having a stepped slope, the height (D) and the width (L) of one step of the stepped slope being larger or smaller toward bottom portions of the concavo-convex, the height (D) of the one step of the stepped slope being 0.01 to 100 μm, the width (L) of one step of the stepped slope being 0.01 to 100 μm.

FIG.1

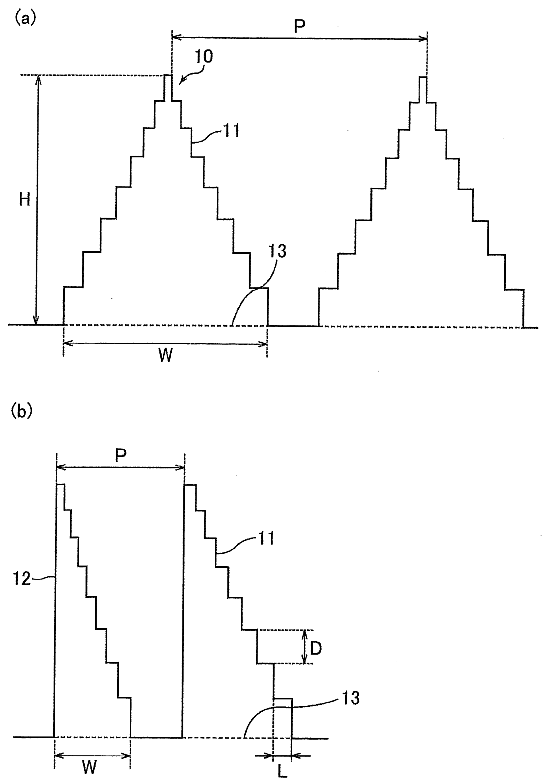


EP 2 687 877 A1

## Description

TECHNICAL FIELD

The present invention relates to a light-concentrating film and a solar cell module.

BACKGROUND ART

In recent years, in response to the emerging energy resource problems and global environmental problems, the photovoltaic power generation has increased in importance. Thus, expansion of use of the photovoltaic power generation and development of an energy supply technology have been carried out enthusiastically.

The photovoltaic power generation aims at a general-purpose power-level generating cost from the viewpoint of the cost efficiency. This leads to a demand for a solar cell capable of reducing the module manufacturing cost, and having a high generating efficiency.

As a method for enhancing the generating efficiency, an increase in focusing efficiency to a photovoltaic cell can be considered. Conventionally, as optical members for concentrating light, mention may be made of (1) lenses (spherical and aspherical types), (2) concave mirrors, (3) planar films, and the like.

As the planar films, optical members such as a Fresnel lens have been under development (see, e.g., Patent Literature 1). However, conventional planar films each cannot concentrate light incident at a shallow angle with respect to the in-plane direction of the planar film. When used as a light-concentrating film for solar cell, in order to perform electric power generation with efficiency, the planar film is required to be a so-called tracking type solar cell in which the orientation of the solar battery cell is allowed to track the direction of radiation of sunlight. The tracking type solar cell is a system controlled so as to cause a focusing element to continuously face the direction of the sun. Accordingly, the whole system is in a complicated structure, posing problems in terms of cost and facilities.

Further, as the planar films, optical elements using hologram are also known. For example, mention may be made of a hologram manufactured by fixing a hologram diffraction pattern onto a photosensitive material using laser interference. For the formation of such a hologram diffraction pattern, there is used the following method: for a photosensitive material such as gelatin dichromate, the interference fringes of a reference light and an object light such as a laser light are recorded on the photosensitive material surface, and information of the complex amplitude of the object light is optically fixed on the recording surface.

On the other hand, not a hologram diffraction pattern fixed using laser interference on a photosensitive material but a CGH: Computer Generated Hologram formed by calculating a diffraction pattern by a computer is also proposed.

Patent Literature 2 discloses an optical splitter having at least one first optical system, a hologram element having a diffraction grating pattern for splitting light emitted radially from the first optical system into a plurality of luminous fluxes, and focusing the luminous fluxes to a plurality of spots, and a plurality of second optical systems with the light-receptive parts disposed at positions corresponding to the plurality of spots. It is described that determination of the optical phase of the diffraction plane of the hologram element can be designed by a computer generated hologram technology using a computer. However, such a conventional hologram element cannot concentrate incident light in a wide angular range.

Incidentally, Patent Literature 3 discloses that the computer generated hologram is calculated using Fourier transform. However, for the computer generated hologram disclosed in Patent Literature 3, the base material is quartz, and the resulting gradation pattern also remains on the quartz surface. For this reason, the uses thereof are limited to display devices and the like, and the computer generated hologram is not used for light concentration.

CITATION LIST

Patent Literature

[Patent Literature 1] JP-B 3687836
[Patent Literature 2] JP-A 2002-228819
[Patent Literature 3] JP-A 2004-206254

Non-Patent Literature

[Non-Patent Literature 1] Glenn Rasenberg, et al., "Holographic planar concentrator increases solar-panel efficiency", Laser Focus World Japan, Japan, 2009, vol. 2, p.26-28

## SUMMARY OF INVENTION

### Technical Problem

The computer generated holograms used in conventional optical elements are only those having a pattern of spatial modulation degree due to binary gradation. Thus, even when the computer generated holograms are applied to light-concentrating films, it is not possible to concentrate incident light in a wide angular range.

An object of the present invention is to provide a light-concentrating film capable of concentrating incident light in a wide angular range and a solar cell module including the light-concentrating film.

### Solution to Problem

An aspect of the present invention is a light-concentrating film made of an organic material, the light-concentrating film having a repeating structure of fine concavo-convex on at least one surface, the height (H) of the concavo-convex being 0.1 to 100 μm, and the frequency (P) of the concavo-convex being 0.1 to 500 μm, the concavo-convex each having a stepped slope, the height (D) and the width (L) of one step being larger or smaller toward bottom portions of the concavo-convex, the height (D) of one step being 0.01 to 100 μm, the width (L) of one step being 0.01 to 100 μm.

Another aspect of the present invention is a solar cell module provided with the light-concentrating film.

### Advantageous Effects of Invention

Because of the structure described above, the light-concentrating film of the present invention enables concentration of light in a wide angular range (e.g. omnidirectional light concentration). Also, a light-concentrating film with long-term stability can be provided by preparing the light-concentrating film of the present invention using a fluororesin. For use in solar cell modules, an improvement in focusing efficiency leads to improvement in generating efficiency and reduction in cost.

## BRIEF DESCRIPTION OF DRAWINGS

Fig. 1 is a cross-sectional view illustrating a repeating structure of concavo-convex of the light-concentrating film of the present invention.
Fig. 2 is a schematic front view illustrating a light-concentrating film of one embodiment of the present invention.
Fig. 3 is a schematic view illustrating one embodiment of the light-concentrating film of the present invention.
Fig. 4 is a schematic view illustrating another embodiment of the light-concentrating film of the present invention.
Fig. 5 is a schematic view illustrating another embodiment of the light-concentrating film of the present invention.
Fig. 6 is a schematic view illustrating another embodiment of the light-concentrating film of the present invention.
Fig. 7 is a schematic block diagram illustrating an example of a Fouries transform device.
Fig. 8 is a schematic view illustrating one embodiment of the solar cell module of the present invention.
Fig. 9 is a schematic view illustrating another embodiment of the solar cell module of the present invention.
Fig. 10 is a multilevel gradation pattern of a computer generated hologram determined by calculation using discrete Fourier transform.
Fig. 11 illustrates a cross-sectional shape of a mold prepared in Example 1.
Fig. 12 illustrates a cross-sectional shape of an ETFE film having a multilevel gradation pattern formed on its surface.
Fig. 13 is a schematic view illustrating an example of a process of forming a light-concentrating film by bringing a mold into contact with an organic material.

## EMBODIMENT OF INVENTION

The present invention is described in detail in the following.

The light-concentrating film of the present invention has a repeating structure of fine concavo-convex on at least one surface. Fig. 1 is a cross-sectional view illustrating an example of a repeating structure of fine concavo-convex of the light-concentrating film of the present invention. Concavo-convex 10 in the repeating structure of concavo-convex each have a stepped slope on at least a part of its surface. Fig. 1 (a) is a schematic cross-sectional view of a repeating structure including concavo-convex 10 that each have stepped slopes 11 formed symmetrically on the surface and are repeatedly arranged. Fig. 1 (b) is a schematic cross-sectional view of a repeating structure including concavo-convex 10 that each include a stepped slope 11 and an upstanding portion 12, the stepped slope 11 being formed on a part of

the surface of each of the concavo-convex 10, and the upstanding portion 12 standing substantially perpendicular to the plane containing a bottom portion 13. In Fig. 1, the stepped slope has eight steps that are formed such that the height (D) and the width (L) of one step are larger toward the bottom portions 13 of the concavo-convex 10.

The concavo-convex 10 each may be a substantially tapered concave or convex. Alternatively, the repeating structure of concavo-convex may include a plurality of linear concave or linear convex formed in substantially parallel.

The light-concentrating film of the present invention may have a repeating structure of fine concavo-convex on one surface, with the other surface being smooth. Alternatively, the light-concentrating film may have a repeating structure of fine concavo-convex on both surfaces. Light may impinge on either surface. Design properties may be imparted to the light-concentrating film through use of the shape of concavo-convex.

The height (D) and the width (L) of one step are larger toward bottom portions 13 of the concavo-convex 10. Such a structure enables a high focusing efficiency. The height (D) and the width (L) of one step may be smaller toward bottom portions 13 of the concavo-convex 10.

The height (D) and the width (L) of one step preferably non-linearly increase toward the bottom portions 13.

In the light-concentrating film of the present invention, the height (H) of the concavo-convex is preferably 0.1 to 100 $\mu$m, and more preferably 0.5 to 30 $\mu$m.

In the light-concentrating film of the present invention, the frequency (P) of the concavo-convex is preferably 0.1 to 500 $\mu$m, and more preferably 1 to 10 $\mu$m.

In the light-concentrating film of the present invention, the height (D) of one step is preferably 0.01 to 100 $\mu$m, and more preferably 0.03 to 0.3 $\mu$m.

In the light-concentrating film of the present invention, the width (L) of one step is preferably 0.01 to 100 $\mu$m, and more preferably 0.1 to 10 $\mu$m.

In the light-concentrating film of the present invention, the width (W) of the concavo-convex is preferably 0.1 to 500 $\mu$m, and more preferably 1 to 10 $\mu$m. The relation between the frequency (P) and the width (W) of the concavo-convex preferably satisfy $P - W \geq 0$.

The embodiments of the present invention are described in more detail based on figures. Fig. 2 is a schematic front view of a light-concentrating film of a first embodiment of the present invention, and Fig. 3 is a perspective schematic view of a light-concentrating film of one embodiment of the present invention. The light-concentrating film 300 of the present embodiment has a repeating structure of a plurality of linear concavo-convex 31, and the concavo-convex 31 are concentrically arranged, as illustrated in Figs. 2 and 3. The dashed-dotted line in Fig. 3 represents a center axis of the repeating structure of concavo-convex concentrically arranged on the surface of the light-concentrating film. The frequency (P) of the concavo-convex is smaller toward the outer periphery, and is smallest at the outer periphery. Though each of stepped slopes of the concavo-convex 31 faces toward the center of the concentric circles in the present embodiment, it may face toward the outer periphery of the concentric circles. Alternatively, both a stepped slope facing toward the center of the circles and that facing toward the outer periphery may be formed. The repeating structure of concavo-convex may be inverted positive-negative in up and down.

The concavo-convex 31 each include, as illustrated in Fig. 3, a stepped slope 32 and an upstanding portion 33 standing substantially perpendicular to the plane containing a bottom portion, and have a substantially triangle cross-section. Fig. 1 (b) is a cross-sectional schematic view illustrating a cross-section of concavo-convex 31. In the present embodiment, the stepped slope has seven or eight steps. The concavo-convex 31 each may include two stepped slopes as illustrated in Fig. 1 (a).

According to the first embodiment, a light-concentrating film having concavo-convex with two stepped slopes can have a better light concentrating properties than a light-concentrating film with concavo-convex with one stepped slope, and thereby can efficiently concentrate light throughout a day.

Fig. 4 illustrates a second embodiment of the light-concentrating film having a repeating structure of concavo-convex. As illustrated in Fig. 4, a light-concentrating film 400 of the present embodiment has a repeating structure including a plurality of convex tapered structures 41 that are repeatedly arranged. Each convex tapered structure 41 may have a shape of a pyramid such as a triangular pyramid or a quadrangular pyramid, a truncated pyramid, a circular cone, a truncated circular cone, or the like.

Preferred among these is a quadrangular pyramid because it enables a high efficiency of light focusing not depending on the light incident angle. In the present embodiment, the tapered structures are convex quadrangular pyramids.

When the tapered structure is a quadrangular pyramid, the quadrangular pyramid may have a quadrate or rectangular bottom portion 43. The bottom portion 43 is preferably 0.3 to 30 $\mu$m on a side, and more preferably 1 to 10 $\mu$m on a side. The tapered structure preferably has an apex angle of 5 to 150 degrees, and more preferably 30 to 90 degrees. When the tapered structure is a circular cone, the circular bottom portion preferably has a diameter of 100 to 4000 $\mu$m, and more preferably 200 to 2000 $\mu$m. The maximum distance between two adjacent apexes of the concavo-convex is preferably such that no reflection of incident light occurs, and is more preferably 0.1 to 200 $\mu$m.

The repeating structure of concavo-convex 400 may include a plurality of tapered structures of substantially

the same shape or of several different shapes. The tapered structures may be arranged in a positive grid pattern, a hound's-tooth pattern, a close packing pattern based on a hexagonal shape, or the like. Alternatively, the tapered structures may be randomly arranged.

The light-concentrating film of the second embodiment may have a structure in which a plurality of concave tapered structures 51 are repeatedly arranged, as illustrated in Fig. 5. The light-concentrating film 500 of the present embodiment has a repeating structure of concavo-convex including a plurality of concave tapered structures 51 that are repeatedly arranged. Each concave tapered structure 51 may have a shape of a pyramid such as a triangular pyramid or a quadrangular pyramid, a truncated pyramid, a circular cone, a truncated circular cone, or the like. A preferable size of the tapered structure is the same as that in the light-concentrating film 400. The concave tapered structure 51 may have a repeating structure of fine concavo-convex on its surfaces

According to the second embodiment, a light-concentrating film that has good light concentrating properties and can efficiently concentrate light throughout a day can be provided.

Fig. 6 illustrates a third embodiment of the light-concentrating film having a repeating structure of concavo-convex. In the light-concentrating film 600 of the present embodiment, a plurality of linear concavo-convex 61 are arranged in substantially parallel, as illustrated in Fig. 6. The concavo-convex 61 each have two stepped slopes 62 and a substantially isosceles triangle cross-section. Though the cross-sections of the concavo-convex in the present embodiment have substantially the same shape, linear concavo-convex of several different shapes may be formed.

The number of steps of the stepped slope is seven or eight in the present embodiment described above, but is not limited as long as it is greater than three. The number of the steps is preferably 4 to 32. Also, concavo-convex each may have a different number of steps. When the repeating structure of concavo-convex is formed of a multilevel gradation pattern resulting from calculation by the discrete Fourier transform, the number of the steps of the stepped slope is an exponent of 2 (a power of 2). A preferred repeating structure of concavo-convex includes concavo-convex that have a stepped slope with eight steps and are repeatedly arranged because such a repeating structure enables concentration of incident light in a wide angular range with a high efficiency.

The light-concentrating film of the present invention is preferably a transmission type light-concentrating film. The "transmission type light-concentrating film" means a light-concentrating film for emitting light incident upon one side of the light-concentrating film from the side opposite to the light incident side.

The light-concentrating film of the present invention preferably has a multilevel gradation pattern. The inclusion of the multilevel gradation pattern enables the in-plane light concentration in a wide angular range. The multilevel gradation pattern is a pattern also referred to as a computer generated multilevel hologram grating pattern, or the like.

The multilevel gradation pattern preferably forms a computer generated hologram. Namely, the light-concentrating film of the present invention preferably includes a computer generated hologram having a multilevel gradation pattern. The computer generated hologram is not formed by formation of interference fringes of a reference light and an object light. Therefore, as a material for forming a light-concentrating film, a photosensitive material is not required to be used. Thus, it is possible to form a hologram having durability.

The "multilevel gradation pattern" in the present description is a pattern having a multilevel gradation calculated by a computer. The "multilevel gradation" means a gradation having three or more values, and is distinguished from binary gradation. Further, it is also distinguished from a waveform pattern including phase information recorded therein such as a hologram diffraction pattern fixed on an organic material using laser interference. Herein, "gradation" means the degree of changes in film thickness of the light-concentrating film. For example, the light-concentrating films having a multilevel gradation pattern results in those having film thickness values of three or more stages.

The multilevel gradation pattern is preferably a pattern calculated using discrete Fourier transform. For a computer generated hologram calculated using conventional Fourier transform, calculation of a hologram for performing light concentration in a wide angular range requires a large capacity of processing. This makes it impossible to calculate a large-area computer generated hologram for use in the light-concentrating film. Thus, the computer generated holograms for use in the light-concentrating film have been limited to those with binary gradation.

Use of discrete Fourier transform dramatically improves the operation speed, which enables the calculation of a high-quality and large-area computer generated hologram. This makes the computer generated hologram to be applicable to the light-concentrating film.

The discrete Fourier transform can be carried out using a Fourier transform device. The Fourier transform device is a Fourier transform device which executes discrete Fourier transform on the input data of N points (N is an integer of 2 or more). The Fourier transform device includes: a phase correction part for changing the phases of input data of N points, and generating m groups (m is an integer of 2 or more) of phase corrected data of N points; a Fourier transform part for subjecting respective groups of phase corrected data generated at the phase correction part to discrete Fourier transform in parallel, and generating m groups of converted data of N points; and a synthesizer for synthesizing m groups of the converted data of N points generated at the Fourier transform part, and generating synthetic data of L points (L is an integer m times as large as N). Preferably, the phase correction part multiplies the input data by the power of a rotation factor having periods of L points, and thereby generates phase corrected data, and the Fourier transform

part executes discrete Fourier transform of N points using the power of the rotation factor having periods of N points on each group of phase corrected data. The input data may be appropriately set so as to obtain the objective characteristics of the light-concentrating film, and have no particular restriction.

The phase correction part includes 0th to (m-1)th phase correctors for changing the phases of the input data of N points, and operating in parallel with one another. The q-th (q is an integer of 0 to m-1) phase corrector preferably multiplies the input data by the integral multiple power of q of the rotation factor having periods of L points, and thereby generates the phase corrected data.

Preferably, the q-th phase corrector multiplies the k-th (k is an integer of 0 to N-1) input data x(k) of the input data of N points by qk-th power of the rotation factor $W_L$ specified by the following equation (A), and thereby calculates the phase corrected data $x_c(k,q)$ expressed by the following equation (B); and the Fourier transform part executes discrete Fourier transform of the N points based on the following equation (D) using the rotation factor $W_N$ specified by the following equation (C) on the phase corrected data $x_c(k,q)$ outputted from the q-th phase corrector, and generates the converted data X(mp+q) (p is an integer of 0 to N-1) of the N points.

[Math. 1]

$$W_L = \exp\left[-i\frac{2\pi}{L}\right] \quad \cdots (A)$$

[Math. 2]

$$x_C(k,q) = x(k)\,W_L^{qk} \quad \cdots (B)$$

[Math. 3]

$$W_N = \exp\left[-i\frac{2\pi}{N}\right] \quad \cdots (C)$$

[Math. 4]

$$X(mp+q) = \sum_{k=0}^{N-1} x_C(k,q)\,W_N^{pk} \quad \cdots (D)$$

The Fourier transform device preferably further includes a phase corrector for adjusting the phase of the synthetic data.

The Fourier transform part preferably has a function of executing high-speed Fourier transform of N points.

Fig. 7 is a block diagram schematically showing one example of the Fourier transform device. As shown in Fig. 7, a Fourier transform device 75 includes a sampling circuit 70, a phase correction part 71, a Fourier transform part 72, a synthesizer 73, and a phase corrector 74. The sampling circuit 70 samples input data x(k) (k is an integer of 0 to N-1) of N points, and branches the input data x(k) into m groups (m is an integral multiple of N) of input data x(k), x (k), ..., x (k) and outputs them to the phase correction part 71.

Further, the phase correction part 71 includes 0th to m-1th phase correctors $71_0$ to $71_{m-1}$ for changing the phases of the input data x(k), and operating in parallel with one another. The 0th to m-1th phase correctors $71_0$ to $71_{m-1}$ generate phase corrected data $x_c(k,0)$ to $x_c(k,m-1)$, respectively, and output them to the Fourier transform part 72.

Further, the Fourier transform part 72 includes a plurality of FFT computing units $72_0$ to $72_{m-1}$ for executing FFT (fast Fourier transform) of N points. The FFT computing units $72_0$ to $72_{m-1}$ execute FFT on the phase corrected data of N points inputted from the phase correctors $71_0$ to $71_{m-1}$, respectively, and output the converted data of the processing results to the synthesizer 73. Further, the synthesizer 73 synthesizes m groups of converted data of N points inputted from the FFT computing unit 72 with a method described later, generates synthetic data X(n) (n is an integer of 0 to L-1) of a total of L (= mN) points, and outputs them to the phase corrector 74. Then, the phase corrector 74 changes the phase of the synthetic data X(n) in a prescribed amount, and generates output data, and outputs it. The

method of executing calculation using discrete Fourier transform is described in details in JP-A 2004-206254. Further, the multilevel gradation pattern can be obtained using, other than discrete Fourier transform, iterative Fourier transform. The calculation methods are described in details in Non-Patent Literature ("Applied Optics", 1994, vol.33, pp 863-867).

For the light-concentrating film, the light transmittance at a wavelength of 550 nm for incidence at an angle of 0° to 89° with respect to the direction of the normal to the light-concentrating film is preferably an average of 80% or more. It is more preferably an average of 90% or more, and further preferably an average of 95% or more. By increasing the light transmittance of the organic material forming the light-concentrating film, it is also possible to improve the focusing efficiency. Further, by increasing the light transmittance, it is possible to suppress deterioration due to heat storage and the like. These enable long-term use, which allows the light-concentrating film to be used in particular preferably for solar cell use or other uses. The light transmittance can be measured by a method using a UV-visible spectrophotometer (U-4100 Spectrophotometer, manufactured by Hitachi High-Technologies Corporation).

Further, for the light-concentrating film, the light transmittance at a wavelength of 550 nm, for incidence at an angle of 0° to 89° with respect to the direction of the normal to the light-concentrating film is preferably 80% or more at substantially all angles. The light transmittance is more preferably 90% or more, and further preferably 95% or more. Incidentally, the angle of 0° with respect to the normal direction represents the angle of the vertical axis. Whereas, the angle of 89° with respect to the normal direction represents the angle of the horizontal axis of 1°. Incidentally, for the light transmittance, there can be adopted a value obtained by averaging the values measured at an interval of 2° in the range of 0 to 89° with the number of measurement values. It is also preferable that the light transmittance at a wavelength of 550 nm for incidence at an angle of 0 to 89° with respect to the direction of the normal to the light-concentrating film is the light transmittance at a wavelength of 550 nm for incidence upon a region having a multilevel gradation pattern.

The light-concentrating film of the present invention is made of an organic material. Conventional optical elements using hologram are produced by forming a hologram diffraction pattern onto a photosensitive material such as gelatin dichromate. However, the photosensitive material lacks the durability (moisture resistance, weather resistance). For this reason, when the planar film having the hologram diffraction pattern is used for a solar cell, it is to be mounted in the inside of the solar battery cell. This results in a solar battery cell of the total internal reflection system as disclosed in, for example, Non-Patent Literature 1. Therefore, the solar cell does not concentrate light in a wide angular range (omnidirectional light concentration) in terms of the structure. The light-concentrating film of the present invention is made of an organic material, and thereby has high durability and long term stability.

For the organic material, the refractive index at a wavelength of 350 to 800 nm is preferably 1.30 to 1.65. The upper limit of the refractive index is more preferably 1.60, further preferably 1.55, and especially preferably 1.45. The refractive index can be measured by a method using an Abbe refractometer (Digital thermometer 2T, manufactured by ATAGO CO. LTD.). For the measurement, measuring was performed at 25°C, and as a light source wavelength, a 589-nm sodium D line was used. Incidentally, the optimum refractive index for light-concentrating film use is preferably, for example, 1.40. It is also preferably 1.42.

The organic material has no particular restriction. However, it is preferably a thermoplastic resin, and is preferably, for example, at least one compound selected from the group consisting of PMMA (polymethyl methacrylate), PC (polycarbonate), PEN (polyethylene naphthalate), PET (polyethylene terephthalate), TAC (triacetyl cellulose), PES (polyether sulfone), and fluororesin. The thermoplastic resins are also so-called weather resistant organic materials.

Further, other than the thermoplastic resins, there can also be used polymer materials such as curable resins described later as coating layers over the resins, organic/inorganic nanocomposite materials for use as sol/gel materials and the like, and other materials.

The organic material is also preferably a fluororesin. Conventionally, for plastic type optical members, PMMA (polymethyl methacrylate) materials have been used. However, for forming, additives such as a plasticizer and a thermal oxidation inhibitor are added. Even when the materials are each used as a focusing element for solar cell, there is a problem such as yellowing (increase in $\Delta$YI value), which makes the practical use thereof impossible.

The fluororesin is excellent in weather resistance, heat resistance, anti-water vapor permeability, transparency, and the like. This prevents deterioration of the material due to sunlight and the like, which can provide a light-concentrating film having long-term durability. Further, the fluororesin is also excellent in optical transparency.

The fluororesin has no particular restriction so long as it is a melt-processable fluororesin. However, it is preferably a homopolymer or a copolymer having a repeating unit derived from at least one fluorinated ethylenic monomer.

The fluororesin may be the one resulting from polymerization of only fluorinated ethylenic monomers, or may be the one resulting from polymerization of fluorinated ethylenic monomers and ethylenic monomers not having a fluorine atom.

The fluororesin preferably has a repeating unit derived from at least one fluorinated ethylenic monomer selected from the group consisting of vinyl fluoride (VF), tetrafluoroethylene [TFE], vinylidene fluoride [VdF], chlorotrifluoroethylene [CTFE], hexafluoropropylene [HFP], hexafluoroisobutene, a monomer represented by $CH_2=CZ^1(CF_2)_nZ^2$ (where $Z^1$ is H or F, $Z^2$ is H, F, or Cl, and n is an integer of 1 to 10), perfluoro(alkyl vinyl ether) [PAVE] represented by $CF_2=CF-ORf^1$ (where $Rf^1$ represents a perfluoroalkyl group having 1 to 8 carbon atoms), and an alkyl perfluorovinyl ether derivative

represented by $CF_2$=CF-O-$CH_2$-$Rf^2$ (where $Rf^2$ is a perfluoroalkyl group having 1 to 5 carbon atoms).

As the PAVE, mention may be made of perfluoro (methyl vinyl ether) [PMVE], perfluoro(ethyl vinyl ether) [PEVE], perfluoro(propyl vinyl ether) [PPVE], perfluoro(butyl vinyl ether), or the like. Out of these, PMVE, PEVE, or PPVE is more preferable.

The alkyl perfluorovinyl ether derivative is preferably the one in which $Rf^2$ is a perfluoroalkyl group having 1 to 3 carbon atoms, and more preferably $CF_2$=CF-O-$CH_2$-$CF_2CF_3$.

The fluororesin may have a repeating unit derived from an ethylenic monomer not having a fluorine atom. In view of keeping the heat resistance, the chemical resistance, and the like, it is also one of preferable modes that the fluororesin has a repeating unit derived from an ethylenic monomer having 5 or less carbon atoms. It is also preferable that the fluororesin has at least one non-fluorine-containing ethylenic monomer selected from the group consisting of ethylene, propylene, 1-butene, 2-butene, vinyl chloride, vinylidene chloride, and unsaturated carboxylic acids.

The unsaturated carboxylic acid is preferably the one having at least one copolymerizable carbon-carbon unsaturated bond per molecule, and having at least one carbonyloxy group [-C(=O)-O-] per molecule, and may be aliphatic unsaturated monocarboxylic acid, or may be aliphatic unsaturated polycarboxylic acid having two or more carboxyl groups. For example, mention may be made of the unsaturated carboxylic acids described in WO 2005/100420 A1.

The aliphatic unsaturated carboxylic acid is preferably at least one selected from the group consisting of (meth) acrylic acid, crotonic acid, maleic acid, maleic anhydride, fumaric acid, itaconic acid, itaconic anhydride, citraconic acid, citraconic anhydride, mesaconic acid, and aconitic acid.

The fluororesin is preferably at least one selected from the group consisting of polychlorotrifluoroethylene [PCTFE], ethylene [Et]/TFE copolymer [ETFE], Et/CTFE copolymer, CTFE/TFE copolymer, TFE/HFP copolymer [FEP], TFE/PAVE copolymer [PFA], and polyvinylidene fluoride [PVdF], and more preferably at least one fluororesin selected from the group consisting of PCTFE, ETFE, CTFE/TFE copolymer, FEP, and PFA.

For the chlorotrifluoroethylene [CTFE]/tetrafluoroethylene [TFE] copolymer, the mole ratio of CTFE units to TFE units is preferably CTFE:TFE = 2:98 to 98:2, more preferably 5:95 to 90:10, and further preferably 20:80 to 90:10. When the CTFE units are too small in amount, melt processing tends to become difficult. Too much amount may deteriorate the heat resistance and the chemical resistance during forming.

The CTFE/TFE copolymer is preferably a copolymer including CTFE, TFE, and a monomer copolymerizable with CTFE and TFE. As the monomers copolymerizable with CTFE and TFE, mention may be made of ethylene, VdF, HFP, a monomer represented by $CH_2$=$CZ^1(CF_2)_nZ^2$ (where $Z^1$ is H or F, $Z^2$ is H, F, or Cl, and n is an integer of 1 to 10), perfluoro (alkyl vinyl ether) [PAVE] represented by $CF_2$=CF-$ORf^1$ (where $Rf^1$ represents a perfluoroalkyl group having 1 to 8 carbon atoms), an alkyl perfluorovinyl ether derivative represented by $CF_2$=CF-O-$CH_2$-$Rf^5$ 5 (where $Rf^5$ represents a perfluoroalkyl group having 1 to 5 carbon atoms), and the like. Out of these, it is preferably at least one selected from the group consisting of ethylene, VdF, HFP, and PAVE, and more preferably PAVE.

As the PAVE, mention may be made of perfluoro (methyl vinyl ether) [PMVE], perfluoro(ethyl vinyl ether) [PEVE], perfluoro(propyl vinyl ether) [PPVE], perfluoro(butyl vinyl ether), or the like. Out of these, PMVE, PEVE, or PPVE is more preferable.

The alkyl perfluorovinyl ether derivative is preferably the one in which $Rf^5$ is a perfluoroalkyl group having 1 to 3 carbon atoms, and more preferably $CF_2$=CF-O-$CH_2$-$CF_2CF_3$.

The CTFE/TFE copolymer preferably includes monomer units derived from monomers copolymerizable with CTFE and TFE in an amount of 0.1 to 10 mol%, and a CTFE unit and a TFE unit in a total amount of 90 to 99.9 mol%. When the copolymerizable monomer units are too small in amount, they tend to be inferior in formability, environmental stress cracking resistance, and stress cracking resistance. When the copolymerizable monomer units are too large in amount, the resulting product tends to be inferior in heat resistance, mechanical characteristics, and productivity. The lower limit of the amount of the monomer units derived from monomers copolymerizable with CTFE and TFE is more preferably 0.5 mol%, and the upper limit is more preferably 5 mol%.

FEP is preferable in that it can provide the one particularly excellent in heat resistance. FEP has no particular restriction. However, FEP is preferably a copolymer including a TFE unit in an amount of 70 to 99 mol% and a HFP unit in an amount of 1 to 30 mol%, and more preferably a copolymer including a TFE unit in an amount of 80 to 97 mol% and a HFP unit in an amount of 3 to 20 mol%. When the amount of the TFE unit is less than 70 mol%, the mechanical physical properties tend to be reduced. When the amount exceeds 99 mol%, the melting point becomes too high. Thus, the formability tends to be reduced.

FEP may be a copolymer including TFE, HFP, and a monomer copolymerizable with TFE and HFP. The monomers may be the monomers exemplified as the monomers copolymerizable with CTFE and TFE. As the monomers, mention may be made of perfluoro(alkyl vinyl ether) [PAVE] represented by $CF_2$=CF-$OR_f^6$ (where $R_f^6$ represents a perfluoroalkyl group having 1 to 5 carbon atoms), a vinyl monomer represented by $CZ^3Z^4$=$CZ^5(CF_2)_nZ^6$ (where $Z^3$, $Z^4$, and $Z^5$ are the same or different, and each represent a hydrogen atom or a fluorine atom, $Z^6$ represents a hydrogen atom, a fluorine atom, or a chlorine atom, and n represents an integer of 2 to 10), an alkyl perfluorovinyl ether derivative

represented by $CF_2$=CF-$OCH_2$-$Rf^7$ (where $Rf^7$ represents a perfluoroalkyl group having 1 to 5 carbon atoms), and the like. Out of these, it is preferably PAVE. The PAVE and the alkyl perfluorovinyl ether derivative are the same as those exemplified as the monomers copolymerizable with CTFE and TFE.

The FEP preferably includes monomer units derived from monomers copolymerizable with TFE and HFP in an amount of 0.1 to 10 mol%, and a TFE unit and a HFP unit in a total amount of 90 to 99.9 mol%. When the amount of the copolymerizable monomer units is less than 0.1 mol%, the resulting product tends to be inferior in formability, environmental stress cracking resistance, and stress cracking resistance. When the amount exceeds 10 mol%, the resulting product tends to be inferior in heat resistance, mechanical characteristics, productivity, and the like.

PFA is preferable in that it can provide the one particularly excellent in heat resistance. PFA has no particular restriction. However, PFA is preferably a copolymer including a TFE unit in an amount of 70 to 99 mol% and a PAVE unit in an amount of 1 to 30 mol%, and more preferably a copolymer including a TFE unit in an amount of 80 to 98.5 mol% and a PAVE unit in an amount of 1.5 to 20 mol%. When the amount of the TFE unit is less than 70 mol%, the mechanical physical properties tend to be reduced. When the amount exceeds 99 mol%, the melting point becomes too high. Thus, the formability tends to be reduced.

As the PAVE, the foregoing ones may be mentioned. Out of these, it is more preferably at least one selected from the group consisting of PMVE, PEVE, and PPVE, and further preferably PMVE.

The PFA may be a copolymer including TFE, PAVE, and a monomer copolymerizable with TFE and PAVE. The monomers may be the monomers exemplified as the monomers copolymerizable with CTFE and TFE. As the monomers, mention may be made of HFP, a vinyl monomer represented by $CZ^3Z^4$=$CZ^5(CF_2)_nZ^6$ (where $Z^3$, $Z^4$, and $Z^5$ are the same or different, and each represent a hydrogen atom or a fluorine atom, $Z^6$ represent a hydrogen atom, a fluorine atom, or a chlorine atom, and n represent an integer of 2 to 10), an alkyl perfluorovinyl ether derivative represented by $CF_2$=CF-$OCH_2$-$Rf^7$ (where $Rf^7$ represents a perfluoroalkyl group having 1 to 5 carbon atoms), and the like. The alkyl perfluorovinyl ether derivatives are the same as those exemplified as the monomers copolymerizable with CTFE and TFE.

The PFA preferably includes monomer units derived from monomers copolymerizable with TFE and PAVE in an amount of 0.1 to 10 mol%, and a TFE unit and a PAVE unit in a total amount of 90 to 99.9 mol%. When the amount of the copolymerizable monomer units is less than 0.1 mol% , the resulting product tends to be inferior in formability, environmental stress cracking resistance, and stress cracking resistance. When the amount exeeds 10 mol%, the resulting product tends to be inferior in heat resistance, mechanical characteristics, and productivity.

The ETFE is preferable in that it improves the dynamic physical properties and the like. The content mole ratio of the TFE unit to the ethylene unit is preferably 20:80 to 90:10, more preferably 37:63 to 85:15, and further preferably 38:62 to 80:20.

The ETFE may be a copolymer including TFE, ethylene, and a copolymer including monomers copolymerizable with TFE and ethylene. As the copolymerizable monomers, mention may be made of the monomers represented by the following formulae $CH_2$=$CZ^7R_f^3$, $CF_2$=$CFR_f^3$, $CF_2$=$CFOR_f^3$, and $CH_2$=$C(R_f^3)_2$ (where $Z^7$ represents a hydrogen atom or a fluorine atom, and $R_f^3$ represents a fluoroalkyl group which may contain ether-linkable oxygen atom). Out of these, fluorinated vinyl monomers represented by $CF_2$=$CFR_f^3$, $CF_2$=$CFOR_f^3$ and $CH_2$=$CZ^7R_f^3$ are preferable. More preferred are HFP, perfluoro(alkyl vinyl ether) [PAVE] represented by $CF_2$=CF-$OR_f^4$ (where $R_f^4$ represents a perfluoroalkyl group having 1 to 5 carbon atoms), and fluorinated vinyl monomer represented by $CH_2$=$CZ^7R_f^3$ where $R_f^3$ is a fluoroalkyl group having 1 to 8 carbon atoms.

Specific examples of the fluorinated vinyl monomers represented by the foregoing formulae may include 1,1-dihydroperfluoropropene-1,1,1-dihydroperfluorobutene-1, 1,1,5-trihydroperfluoropentene-1, 1,1,7-trihydroperfluoroheptene-1, 1,1,2-trihydroperfluorohexene-1, 1,1,2-trihydroperfluorooctene-1, 2,2,3,3,4,4,5,5-octafluoropentyl vinyl ether, perfluoro (methyl vinyl ether), perfluoro (propyl vinyl ether), hexafluoropropene, perfluorobutene-1, 3,3,3-trifluoro-2-(trifluoromethyl)propane-1, and 2,3,3,4,4,5,5-heptafluoro-1-pentene ($CH_2$=$CFCF_2CF_2CF_2H$)

Further, the monomers copolymerizable with TFE and ethylene may be the aliphatic unsaturated carboxylic acids such as itaconic acid and itaconic anhydride.

The monomers copolymerizable with TFT and ethylene are in an amount of preferably 0.1 to 10 mol%, more preferably 0.1 to 5 mol%, and in particular preferably 0.2 to 4 mol% based on the amount of the fluorinated polymers.

The fluororesin is more preferably at least one fluororesin selected from the group consisting of ETFE, PCTFE, EFEP, FEP, and PVdF. For the PMMA conventionally used as a hologram material, the total light transmittance is 90% or less, and particularly, the light absorption on the low wavelength side is large. The ETFE, PCTFE, EFEP, FEP, and PVdF are highly optically transparent materials, and further high in thin film property. Therefore, they suppress the absorption/reflection of light, which can improve the focusing efficiency.

It is also one of preferable modes that the fluororesin is a perhalopolymer. Use of the perhalopolymer results in those excellent in chemical resistance and the like. The perhalopolymer is a polymer in which halogen atoms are bonded to all the carbon atoms forming the main chain of the polymer. The perhalopolymer is preferably at least one selected from the group consisting of the CTFE/TFE copolymer, FEP, and PFA.

The content of respective monomers of the copolymer can be calculated by appropriately combining NMR, FT-IR, elementary analysis, and X-ray fluorescence analysis according to the kind of the monomers.

In the present invention, the fluororesin has no particular restriction, but preferably has a melting point of 160 to 270°C. The molecular weight of the fluororesin is preferably within such a range as to allow the resulting light-concentrating film to express the demanded mechanical characteristics and the like. For example, with the melt flow rate [MFR] as the index of the molecular weight, the MFR at a given temperature within the range of about 230 to 350°C which is the forming temperature range of the fluororesin in general is preferably 0.5 to 100 g/10 min.

In the present description, the melting point of each resin is determined as the temperature corresponding to the maximum value in the fusion heat curve at heating at a rate of 10°C/min using a DSC device (manufactured by SEIKO Co.). The MFR is determined by measuring the weight (g) of the polymer flowing out per unit time (10 min) from a nozzle with a diameter of 2 mm and a length of 8 mm at each temperature and under a load of 5 kg using a melt indexer (manufactured by Toyo Seiki Seisaku-Sho Ltd.).

The fluororesin can be obtained by a conventionally known polymerization method such as suspension polymerization, solution polymerization, emulsion polymerization, or block polymerization. In the polymerization, various conditions such as temperature and pressure, and a polymerization initiator and other additives can be appropriately set according to the composition and amount of the desirable fluororesin.

(Illustration of organic materials)

Below, the organic materials usable for the light-concentrating film of the present invention will be further described. As the organic materials, there can also be used, other than the thermoplastic resins, polymer materials such as curable resins as the coating layers onto the resins and the like, organic/inorganic nanocomposite materials for use as sol/gel materials, and the like.

The curable resins for use as the coating layers onto the resins including thermoplastic resins and the like are each preferably used as a coating onto the base material, or a paint for forming a coating film as the resin simple substance. Namely, when the curable resin is used as a paint, the following procedures are acceptable: the curable resin is applied to the base material, and is cured, then, it is peeled off from the base material to be formed into a film: and if possible, it is processed into the light-concentrating film while being disposed on the base material.

Below, the organic materials will be described.

(Weather resistant organic material)

The organic material forming the light-concentrating film of the present invention has no particular restriction. However, it is preferably a weather resistant organic material. As the weather resistant organic materials, other than the thermoplastic resins, mention may be made of polymer materials such as curable resins and the like as the coating layers onto the resins and the like. The weather resistant organic material is preferably an organic material including a fluororesin. As the organic materials including fluororesins, mention may be made of organic materials including fluororesins and the like, and for example, preferred are organic materials including thermoplastic fluororesins, organic materials including at least one compound selected from the group consisting of (I) fluoroolefin copolymers having a hydroxyl group and/or a carboxyl group, (V) fluorine silicone resins, (VI) homopolymers or copolymers of vinylidene fluoride not having a functional group, and (VII) fluororesins not having a functional group, or at least one organic material selected from the group consisting of the following curable resin compositions (VIII) and the following curable resin compositions (IX).

The thermoplastic fluororesin is preferable in terms of hydrolysis resistance. The organic materials or curable resin compositions including the compounds represented by the (I), (V), (VI), (VII), (VIII), and (IX) are preferable in terms of light resistance. The weather resistant organic material is preferably solvent-soluble.

As the weather resistant organic materials, other than the organic materials including the foregoing compounds, mention may also be made of organic materials including (II) acrylic lacquer resins, (III) acrylic polyol resins, (IV) acrylic silicon resins, and the like. However, from the viewpoint of the track record of use thereof, they are also preferably organic materials including at least one compound selected from the group consisting of (I) fluoroolefin copolymers having a hydroxyl group and/or a carboxyl group, and (III) acrylic polyol resins.

As the fluoroolefin copolymers (I) having a hydroxyl group and/or a carboxyl group, mention may be made of those as described in respective publications such as JP-B S60-21686, JP-A H3-121107, JP-A H4-279612, JP-A H4-28707, and JP-A H2-232221. The number-average molecular weight (by GPG) of the copolymer is 1000 to 100000, and preferably 1500 to 30000. When the molecular weight is less than 1000, the curability and the weather resistance tend to be insufficient. When the molecular weight exceeds 100000, problems tend to occur in workability and coatability.

The hydroxyl value of the fluoroolefin copolymers having a hydroxyl group and/or a carboxyl group is 0 to 200 (mgKOH/g), and preferably 0 to 150 (mgKOH/g). When the hydroxyl group is reduced, curing defects tend to occur. When the hydroxyl value exceeds 200 (mgKOH/g), a problem tends to occur in flexibility.

The acid value of the fluoroolefin copolymers having a hydroxyl group and/or a carboxyl group is 0 to 200 (mgKOH/g), and further preferably 0 to 100 (mgKOH/g). When the acid value is increased, a problem tends to occur in flexibility.

Incidentally, as one of the fluoroolefin copolymers having a hydroxyl group and/or a carboxyl group, a tetrafluoroethylene copolymer can also be used from the viewpoints of the contamination adhesion resistance, the decontaminability, and the rust resistance.

As the fluoroolefin copolymers having a hydroxyl group and/or a carboxyl group, mention may be made of commercially available products such as ZEFFLE (registered trademark) manufactured by Daikin Industries, Ltd., LUMIFLON (registered trademark) manufactured by ASAHI GLASS Co., Ltd., CEFRAL COAT (registered trademark) manufactured by CENTRAL GLASS Co., Ltd., FLUONATE (registered trademark) manufactured by Dainippon Ink and Chemicals, Incorporated, and ZAFLON (registered trademark) manufactured by TOAGOSEI Co., Ltd.

As the acrylic polyol resins (III), for example, mention may be made of polymers of (a) hydroxyl group-containing ethylenically unsaturated monomers such as hydroxyl group-containing (meth) acrylic acid ester, hydroxy vinyl ether, and allyl alcohol, and (b) no hydroxyl group-containing unsaturated monomers such as olefins not containing a hydroxyl group, vinyl ether, allyl ether, vinyl ester, propenyl ester, (meth)acrylic acid ester, vinyl aromatic compound, (meth) acrylonitrile, carboxyl group-containing unsaturated monomers, epoxy group-containing unsaturated monomers, and amino group-containing unsaturated monomers. The acrylic polyol resin may have at least one selected from the group consisting of a hydroxyl group, a carboxyl group, an epoxy group, and an amino group.

The hydroxyl value of the acrylic polyol resin (III) is 0 to 200 (mgKOH/g), and preferably 0 to 100 (mgKOH/g). When the hydroxyl value is increased, a problem tends to occur in flexibility.

The acid value of the acrylic polyol resin (III) is 0 to 200 (mgKOH/g), and further preferably 0 to 100 (mgKOH/g). When the acid value is increased, a problem tends to occur in flexibility.

As the acrylic lacquer resins (II), for example, mention may be made of those which are resins using monomers for use in acrylic polyol resins as raw materials, and have a hydroxyl value of zero and an acid value of 0 to 10.

As the acrylic polyol resins (III) or the acrylic lacquer resin (II), there can be used commercially available products such as DYANAL (registered trademark) manufactured by MITSUBISHI RAYON CO.,Ltd., ACRYDICK (registered trademark) manufactured by Dainippon Ink and Chemicals, Incorporated, HITALOID (registered trademark) manufactured by Hitachi Chemical Co., Ltd., and OLESTER (registered trademark) manufactured by Mitsui Toatsu Chemicals Inc.

As the acrylic silicon resin (IV), for example, mention may be made of the one produced by copolymerizing an acrylic silicon monomer having at least one silane group and a radical polymerizable unsaturated group per molecule with the hydroxyl group-containing ethylenically unsaturated monomers (a) and/or the no hydroxyl group-containing unsaturated monomers (b). The acrylic silicon resin (IV) may have a hydrolyzable silyl group, a hydroxyl group, and an epoxy group.

As the acrylic silicon resins (IV), there can be used commercially available products such as Zemlac (registered trademark) manufactured by KANEKA CORPORATION and Clearmer (registered trademark) manufactured by Sanyo Chemical Industries, Ltd.

Further, an organometallic compound having a hydrolyzable leaving group, an oligomer thereof and/or a cooligomer of two or more of the organometallic compounds are added to the weather resistant organic material. As a result, the resulting mixture can be used as a surface-hydrophilized resin.

The organometallic compound is preferably an organometallic compound represented by the following formula (1):

$$Z^8{}_eM(OR^{22})_dR^{23}{}_f \qquad (1)$$

[where d is an integer of 0, or 1 to 6, e is an integer of 0, or 1 to 5, f is an integer of 0, or 1 to 6 (provided that d+e+f≥3, and that d and f are not 0 at the same time), $Z^8$'s are the same or different, and each is a monovalent organic group having 1 to 5000 carbon atoms, which may contain an oxygen atom, a nitrogen atom, a fluorine atom, and/or a chlorine atom, or a hydrogen atom, M is a metal atom having at least trivalent valence, $R^{22}$' s are the same or different, and each is a monovalent organic group having 1 to 1000 carbon atoms, which may contain an oxygen atom, a nitrogen atom, a fluorine atom, and/or a chlorine atom, a siloxane residue, or a hydrogen atom, and $R^{23}$'s are the same or different, and each is an organic group having 1 to 20 carbon atoms which have chelation ability, and may contain an oxygen atom, a nitrogen atom, a fluorine atom, and/or a chlorine atom]. Particularly preferred is a fluorinated organometallic compound in which at least one of $R^{22}$ or $R^{23}$ is a fluorinated group.

Such organometallic compounds are preferably the compounds represented by the formula (1). The organometallic compounds, oligomers thereof, or cooligomers of two or more thereof are those described in WO 97/11130 A1. However, the organometallic compounds represented by the following formula (2) :

[CHEMICAL 1]

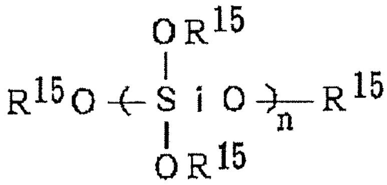

(2)

(where n is an integer of 1 to 20, all of $R^{15}$'s are different or at least two thereof are the same, and each is a monovalent organic group having 1 to 1000 carbon atoms, and may contain an oxygen atom, a nitrogen atom, and/or a silicon atom, and a part or the whole of the hydrogen atoms of the organic groups may be substituted with a fluorine atom, or a fluorine atom and a chlorine atom) excluded in the pamphlet are usable in the present invention.

The organometallic compounds have an action of hydrophilizing the surface of the coating film, and more preferable substituents or molecular weights may be selected and used according to the objective functions and the intended use.

Below, first, a description will be given to a preferred embodiment of the organometallic compounds represented by the formula (1) in the present invention.

The d in the formula (1) is an integer of 0, or 1 to 6, and preferably an integer of 2 to 4 from the viewpoints of the surface concentratability, the hydrolyzability, and the leaving ability.

The e in the formula (1) is an integer of 0, or 1 to 5, and preferably an integer of 0 to 1 from the viewpoints of the surface concentratability and the hydrophilicity.

The f in the formula (1) is an integer of 0, or 1 to 6, and preferably an integer of 0 to 3 from the viewpoints of the surface concentratability, the hydrolyzability, and the leaving ability.

Incidentally, the total amount of d, e and, f is the amount determined by the valence of the metal atom M. However, in the formula (1), any one of $OR^{22}$ or $R^{23}$ is necessary for the contamination adhesion resistance, the surface concentratability, and the hydrolyzability. Therefore, d and f are not 0 at the same time, and the total amount of d, e, and f is at least 3.

In the formula (1), $Z^8$ may be a hydrogen atom, and further, is preferably, for example, a monovalent organic group having 1 to 5000 carbon atoms, which may contain an oxygen atom, a nitrogen atom, a fluorine atom, and/or a chlorine atom as mentioned in the following (1) to (3).

(1) As the organic groups $Z^8$, mention may be made of, for example, $H(CH_2)_p$, $(CH_3)_2CH$, $H(CH_2)_pC=O$, $F(CF_2)_q(CH_2)_p$, $(CF_3)_2CH$, $H(CF_2)_q(CH_2)_p$ (where p is an integer of 0, or 1 to 6, q is an integer of 1 to 10, and a part of fluorine atoms may be substituted with a chlorine atom). The organic groups may be a straight-chain or a branched chain.

Specific examples thereof may include $CH_3$, $CH_3CH_2$, $CH_3CH_2CH_2$, $(CH_3)_2CH$, $CF_3CH_2$, $CF_3CF_2CH_2$, $(CF_3)_2CH$, $F(CF_2)_4CH_2CH_2$, $F(CF_2)_8CH_2CH_2$, and $H(CF_2)_4CH_2$. From the viewpoints of the surface concentratability, the hydrolyzability, and the leaving ability, $CF_3CF_2CH_2$ and $(CF_3)_2CH$ are preferable.

(2) Further, as the organic groups $Z^8$, mention may be made of organic groups having functional groups such as $NH_2$, a secondary amino group, a tertiary amino group, OH, NCO, $CO_2H$, $CO_2Na$, $CO_2K$, $SO_3H$, $SO_2Na$, $SO_3K$, an epoxy group, and an oxyethylene group ($CH_2CH_2O$), and the like.

Specific examples thereof may include $H_2N(CH_2)_3$, OCN $(CH_2)_3$, $CH_3O(CH_2CH_2O)$ $(CH_2)_3$, $CH_3O(CH_2CH_2O)_5$ $(CH_2)_3$, $CH_3O(CH_2CH_2O)_{10}(CH_2)_3$, and a functional group represented by the following formula:

[CHEMICAL 2]

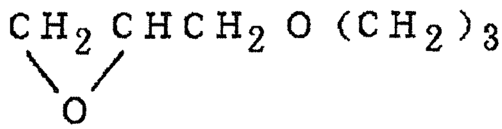

From the viewpoints of the hydrophilicity, the compatibility, and the adhesion, $OCN(CH_2)_3$ and $CH_3O(CH_2CH_2O)_5(CH_2)_3$ are preferable.

(3) Further, as the organic groups $Z^8$, mention may be made of polymerizable organic groups which may contain, for example, an oxygen atom, a nitrogen atom, a fluorine atom, a chlorine atom, and a silicon atom.

The specific examples thereof may include $CH_2=C(CH_3)CO_2(CH_2)_3$, $CH_2=CH$, $CH_2=CHCH_2$, $CH_2=CHO(CH_2)_3$, $CH_2=CHOCO(CH_2)_3$, $CH_2=CHC_6H_4$, and $CH_2=CHCO_2(CH_2)_3$. From the viewpoint of polymerizability and ease of availability, $CH_2=C(CH_3)CO_2(CH_2)_3$ and $CH_2=CHO(CH_2)_3$ are preferable.

Incidentally, in the present invention, also preferred are polymers or copolymers which are obtained by polymerizing or copolymerizing compounds represented by the formula (1), having such polymerizable organic groups, and which have a molecular weight of 2000 to 200000, and preferably 5000 to 20000.

In the formula (1), $R^{22}$'s are the same or different, and each may contain an oxygen atom, a nitrogen atom, a fluorine atom, and/or a chlorine atom. From the viewpoints of the surface concentratability, the hydrolyzability, and the leaving ability, $R^{22}$ is a monovalent organic group having 1 to 1000 carbon atoms, a siloxane residue, or a hydrogen atom. The number of carbon atoms is preferably 1 to 100, and further preferably 1 to 16.

In the formula (1), the monovalent organic groups of $R^{22}$'s are preferably, for example, those represented by $H(CH_2)_m$, $(CH_3)_2CH$, $H(CH_2)_mC=O$, $F(CF_2)_n(CH_2)_m$, $(CF_3)_2CH$, $H(CF_2)_n(CH_2)_m$, $F(CF_2)_n(CH_2)_mC=O$, $H(CF_2)_n(CH_2)_mC=O$, $(F(CF_2)_n(CH_2)_m)_2N$, $((CF_3)_2CH)_2N$, $(H(CF_2)_n(CH_2)_m)_2N$, $F(CF_2)_nO(CF(CF_3)CF_2O)_mCF(CF_3)C=O$, $(F(CF_2)_n(CH_2)_m)_2C=N$, $((CF_3)_2CH)_2C=N$, $(H(CF_2)_n(CH_2)_m)_2C=N$, $F(CF_2)_n(CH_2)_mC=ONR^3$, $H(CF_2)_n(CH_2)_mC=ONR^3$, $F(CF_2)_n(CH_2)_mC=CH_2$, $H(CF_2)_n(CH_2)_mC=CH_2$, $F(CF_2)_n(CH_2)_mC=CF_2$, and $H(CF_2)_n(CH_2)_mC=CF_2$ (where m is an integer of 0, or 1 to 6, n is an integer of 1 to 10, $R^3$ represents an alkyl group having 1 to 6 carbon atoms, in which the alkyl group may be a straight-chain or a branched chain).

Specific examples of the organic groups may include $CF_3CH_2$, $CF_3CF_2CH_2$, $CF_3(CF_2)_2CH_2$, $CF_3(CF_2)_3CH_2CH_2$, $(CF_3)_2CH$, $CF_3(CF_2)_7CH_2CH_2$, $H(CF_2)_2CH_2$, $H(CF_2)_3CH_2$, $H(CF_2)_4CH_2$, $CF_3C=O$, $CF_3CF_2C=O$, $CF_3(CF_2)_6C=O$, and $CF_3(CF_2)_7C=O$. From the viewpoints of the surface concentratability, the hydrolyzability, and the leaving ability, $CF_3CH_2$, $CF_3CF_2CH_2$, $CF_3(CF_2)_2CH_2$, $CF_3(CF_2)_3CH_2CH_2$, $CF_3C=O$, and $CF_3CF_2C=O$ are preferable, and $CF_3CH_2$ and $CF_3CF_2CH_2$ are further preferable.

In the formula (1), examples of the siloxane residue of $R^{22}$'s may include $(Si(OR^{22})_2O)_nR^{22}$ (where $R^{22}$ is the same as the monovalent organic group of the $R^{22}$'s described above).

In the formula (1), $R^{23}$'s may be the same or different, and are each an organic group which may contain a fluorine atom and/or a chlorine atom, and has a chelating ability, and has 1 to 20 carbon atoms, and preferably 2 to 10 carbon atoms from the viewpoints of the surface concentratability, the hydrolyzability, and the leaving ability.

In the present invention, use of the organometallic compound to which such an organic group having a chelating ability is bonded results in more excellent storage stability, reactivity, solubility, and compatibility.

As the compounds which can become such compounds having a chelating ability, preferred are, for example, β-diketanes such as 2,4-pentanedion and 2,4-heptanedion, ketoesters such as methyl acetoacetate, ethyl acetoacetate, and butyl acetoacetate, hydroxycarboxylic acids such as lactic acid, methyl lactate, ethyl lactate, lactic acid ammonium salt, salicylic acid, methyl salicylate, ethyl salicylate, malic acid, ethyl malate, tartaric acid, and ethyl tartrate, or esters or salts thereof, ketoalcohols such as 4-hydroxy-4-methyl-2-pentanone, 4-hydroxy-2-pentanone, 4-hydroxy-2-heptanone, and 4-hydroxy-4-methyl-2-heptanone, amino alcohols such as monoethanolamine, diethanolamine, triethanolamine, N-methyl monoethanolamine, N-ethyl monoethanolamine, N,N-dimethyl ethanolamine, and N,N-diethyl ethanolamine, and enolic active hydrogen compounds such as diethyl malonate, methylolmelamine, methylol urea, and methylolacrylamide. Further preferred are compounds produced by substituting the whole or a part of the hydrogen atoms thereof with a fluorine atom and/or a chlorine atom, and the like from the viewpoint of the surface concentratability.

In the formula (1), examples of the metal atom M may include B, Al, Ga, In, Tl, Sc, Y, La, Ac, Si, Ge, Sn, Pb, Ti, Zr, Hf, As, Sb, Bi, V, Nb, Ta, Te, Po, Cr, Mo, W, At, Mn, Tc, Re, Fe, Co, Ni, Ru, Rh, Pd, Os, Ir, and Pt. From the viewpoints of ease of synthesis and availability, Al, Ti, B, Zr, or Si is preferred, and Si is particularly preferred.

Further, as the oligomers or cooligomers in the present invention, mention may be made of straight-chain, branched-chain, cyclic, three-dimensional, or other oligomers or cooligomers.

In the present invention, the degree of polymerization of the oligomer or the cooligomer is preferably 2 to 100, and further preferably 4 to 20. When the degree of polymerization is reduced, the oligomer or the cooligomer tends to be reduced in boiling point. Accordingly, the oligomer or the cooligomer becomes more likely to volatilize during coating, and becomes less likely to be incorporated. When the degree of polymerization exceeds 100, control of the degree of polymerization becomes difficult during synthesis, or the viscosity of the oligomer or the cooligomer tends to increase. Thus, the oligomer or the cooligomer tends to be inferior in workability. However, when the oligomer or the cooligomer is represented by the formula (1) in which d is 4, e and f are each 0, and, M is Si, and has a fluorine atom, the degree of polymerization thereof is preferably more than 4 and 30 or less from the viewpoints of the coating film outward appearance, the sag resistance, and the alkali resistance.

To the weather resistant organic material, an organometallic compound having a hydrolyzable leaving group, an oligomer thereof, and/or cooligomers of two or more of the organometallic compounds are added. To the resulting hydrophilized resin, a curing agent can be added.

Examples of the curing agent may include isocyanate compounds, block isocyanate compounds, melamine resins, dibasic acids, non-hydrolyzable group-containing silane compounds, epoxy compounds, or acid anhydrides. From the viewpoints of the weather resistance and the acid rain resistance, isocyanates, block isocyanates, and epoxy compounds are preferable.

Examples of the isocyanate compounds and the block isocyanate compounds may include, but are not limited

to, 2,4-tolylene diisocyanate, diphenylmethane-4,4'-diisocyanate, xylylene diisocyanate, isophorone diisocyanate, lysine methyl ester diisocyanate, methylcyclohexyl diisocyanate, trimethyl hexamethylene diisocyanate, hexamethylene diisocyanate, n-pentane-1,4-diisocyanate, trimers thereof, adduct forms thereof, biuret forms thereof, polymers thereof having two or more isocyanate groups, and further blocked isocyanates.

The mixing ratio of the isocyanate and the weather resistant organic material is preferably 0.5 to 5.0, and more preferably 0.8 to 1.2 by NCO/OH (mole ratio). Further, when the isocyanate is of a moisture-curable type, the ratio is preferably 1.1 to 1.5.

Examples of the melamine resins may include, but are not limited to, other than melamine resins, methylolated melamine resins obtained by methylolating melamine, alkyl etherified melamine resins obtained by etherifying methylolated melamines with alcohols such as methanol, ethanol, and butanol.

As the epoxy compounds, mention may be made of, for example, the compounds represented by the following formulae:

[CHEMICAL 3]

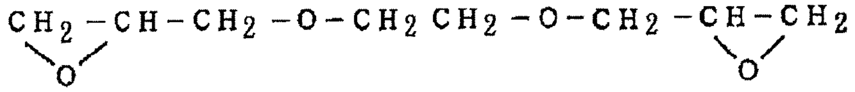
,
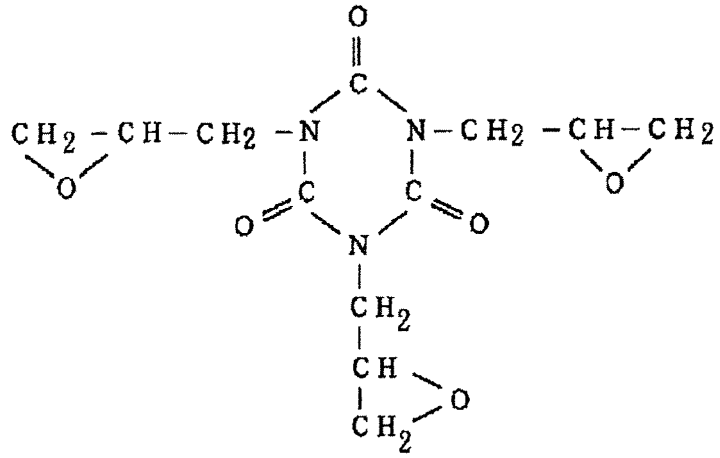
,
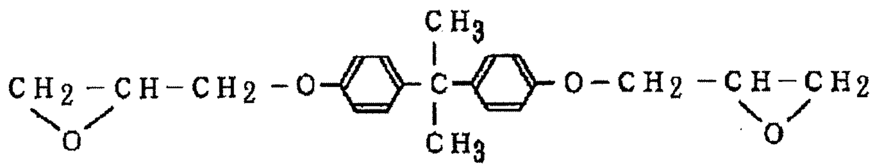

However, these are not exclusive.

Examples of the acid anhydride may include, but are not limited to, phthalic anhydride, trimellitic anhydride, pyromellitic anhydride, 1,2-cyclohexyl dicarboxylic acid anhydride, succinic anhydride, and maleic anhydride.

Further, dibasic acids such as fumaric acid, succinic acid, adipic acid, azelaic acid, sebacic acid, dodecanedioic acid, and 1,2-cyclohexyl dicarboxylic acid are also used as curing agents.

Examples of the curing catalyst may include organotin compounds, organic acidic phosphoric acid esters, organic titanate compounds, reaction products of acidic phosphoric acid esters and amines, saturated or unsaturated polyhydric carboxylic acids or acid anhydrides thereof, organic sulfonic acids, amine type compounds, aluminum chelate compounds, titanium chelate compounds, and zirconium chelate compounds.

Specific examples of the organotin compounds may include dibutyltin dilaurate, dibutyltin maleate, dioctyltin maleate, and dibutyltin diacetate.

As specific examples of the organic acidic phosphoric acid esters, the compounds represented by the following formulae:

[CHEMICAL 4]

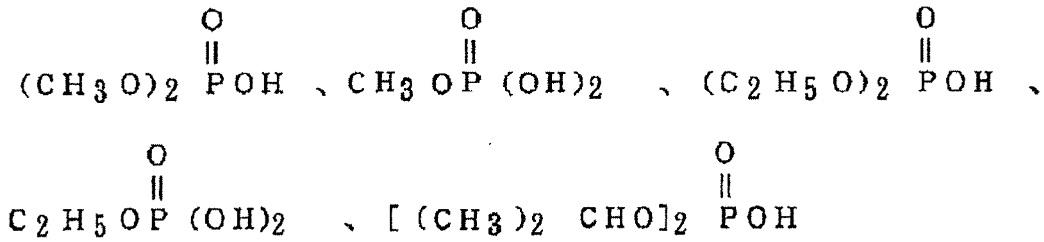

may be mentioned.

Examples of the organic titanate compounds may include titanium acid esters such as tetrabutyl titanate, tetraisopropyl titanate, and triethanolamine titanate.

Further, specific examples of the amine type compounds may include amine type compounds such as butylamine, octylamine, dibutylamine, monoethanolamine, diethanolamine, triethanolamine, diethylenetriamine, triethylenetetramine, oleylamine, cyclohexylamine, benzylamine, diethylaminopropylamine, xylylene diamine, triethylene diamine, guanidine, diphenyl guanidine, 2,4,6-tris(dimethylaminomethyl)phenol, morpholine, N-methylmorpholine, and 1,8-diazabicyclo(5.4.0)undecene-7(DBU), and salts thereof with carboxylic acid and the like, low-molecular-weight polyamide resins resulting from excess polyamines and polybasic acids, and reaction products of excess polyamines and epoxy compounds.

Specific examples of the chelate compound may include aluminum tris(ethyl acetoacetate), aluminum tris(acetyl acetonate), zirconium tetrakis (acetyl acetonate), and diisopropoxy/bis(ethyl acetoacetate)titanate.

As the (VII) fluororesins not having a functional group, homopolymers, copolymers, and the like of vinylidene fluoride described in respective publications such as JP-B S43-10363, JP-A H3-28206 and JP-A H4-189879 can be used, and can also be blended with the resins having the functional groups. Whereas, when resins having no functional group are used, the curing agent or the curing catalyst is not necessarily required to be used.

Further, as the weather resistant organic materials, other than these, the following curable resin compositions (VIII) can also be used. The curable resin composition (VIII) contains (A) a reaction product of hydroxyl group-containing fluorinated copolymer containing a fluoroolefin unit and a hydroxyl group-containing radical-polymerizable unsaturated monomer unit (A-1), and an isocyanate group-containing unsaturated compound having one isocyanate group and at least one radical-polymerizable unsaturated group (A-2), and (B) an acrylic monomer.

As the fluoroolefin units in the hydroxyl group-containing fluorinated copolymer (A-1), mention may be made of one, or two or more of a tetrafluoroethylene (TFE) unit, a chlorotrifluoroethylene (CTFE) unit, a vinyl fluoride (VF) unit, a vinylidene fluoride (VdF) unit, a hexafluoropropylene (HFP) unit, a trifluoroethylene (TrFE) unit, aperfluoro(alkyl vinyl ether) (PAVE) unit, and the like. As the PAVE units, mention may be made of a perfluoromethyl vinyl ether unit and a perfluoropropyl vinyl ether unit.

As the combinations of two or more units including a TFE unit, mention may be made of a TFE/HFP unit, a TFE/PAVE unit, a TFE/ethylene unit, a TFE/vinyl ether unit, a TFE/vinyl ester unit, a TFE/vinyl ester/vinyl ether unit, a TFE/vinyl ether/allyl ether unit, and the like. Out of these, from the viewpoint of excellent mixing into ethylenically unsaturated group-containing monomers, preferred are a TFE/ethylene unit, a TFE/vinyl ether unit, a TFE/vinyl ester unit, a TFE/vinyl ester/vinyl ether unit, a TFE/vinyl ether/allyl ether unit, and the like.

As the combinations of two or more units including a CTFE unit, mention may be made of a CTFE/HFP unit, a CTFE/PAVE unit, a CTFE/ethylene unit, a CTFE/vinyl ether unit, a CTFE/vinyl ester unit, a CTFE/vinyl ester/vinyl ether unit, a CTFE/vinyl ether/allyl ether, and the like. Out of these, from the viewpoint of excellent mixing into ethylenically unsaturated group-containing monomers, preferred are a CTFE/ethylene unit, a CTFE/vinyl ether unit, a CTFE/vinyl ester unit, a CTFE/vinyl ester/vinyl ether unit, a CTFE/vinyl ether/allyl ether unit, and the like.

Similarly, as the combinations of two or more units including a HFP unit, mention may be made of a CTFE/HFP unit, a TFE/HFP unit, a HFP/vinyl ether unit, a HFP/vinyl ester unit, a HFP/vinyl ester/vinyl ether unit, a HFP/vinyl ether/allyl ether unit, and the like. Out of these, from the viewpoint of excellent mixing into ethylenically unsaturated group-containing monomers, preferred are a HFP/vinyl ether unit, a HFP/vinyl ester unit, a HFP/vinyl ester/vinyl ether unit, a HFP/vinyl ether/allyl ether unit, and the like.

As the combinations of two or more units including a VdF unit, mention may be made of a VdF/TFE unit, a VdF/HFP unit, a VdF/TFE/HFP unit, a VdF/CTFE unit, a VdF/TFE/PAVE unit, a VdF/CTFE/TFE unit, a VdF/CTFE/HFP unit, and the like. Out of these, from the viewpoint of excellent mixing into ethylenically unsaturated group-containing monomers, it is preferable that the VdF unit is contained in an amount of 50 mol% or more in the polymer.

Specific examples of the hydroxyl group-containing radical-polymerizable unsaturated monomer unit in the hydroxyl group-containing fluorinated copolymer (A-1) may include hydroxyalkyl vinyl ether and hydroxyalkyl allyl ether

represented by the following formula:

[CHEMICAL 5]

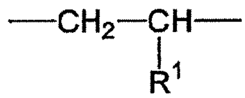

(where, in the formula, $R^1$ is $-OR^2$ or $-CH_2OR^2$ (provided that $R^2$ is an alkyl group having a hydroxyl group)). Examples of $R^2$ are those in which to a straight-chain or branched-chain alkyl group having 1 to 8 carbon atoms, 1 to 3, preferably one hydroxyl group is bonded. Examples thereof may include 2-hydroxyethyl vinyl ether unit, 3-hydroxypropyl vinyl ether unit, 2-hydroxypropyl vinyl ether unit, 2-hydroxy-2-methyl propyl vinyl ether unit, 4-hydroxybutyl vinyl ether unit, 4-hydroxy-2-methylbutyl vinyl ether unit, 5-hydroxy pentyl vinyl ether unit, 6-hydroxy hexyl vinyl ether unit, 2-hydroxyethyl allyl ether unit, 4-hydroxybutyl allyl ether unit, ethylene glycol monoallyl ether unit, diethylene glycol monoallyl ether unit, triethylene glycol monoallyl ether unit, and glycerin monoallyl ether unit. Out of these, particularly, hydroxyalkyl vinyl ether having 3 to 8 carbon atoms, especially, a 4-hydroxybutyl vinyl ether unit or a 2-hydroxyethyl vinyl ether unit is preferable from the viewpoint of easy polymerization.

The hydroxyl group-containing fluorinated copolymer (A-1) preferably further contains a no hydroxyl group-containing non-fluorine vinyl ether unit and/or non-fluorine vinyl ester unit from the viewpoint of enhancing the solubility with acrylic monomers.

Specific examples of the no hydroxyl group-containing non-fluorine vinyl ether unit and/or non-fluorine vinyl ester unit in the hydroxyl group-containing fluorinated copolymer (A-1) may include alkyl vinyl ether and alkyl allyl ether represented by the following formula:

[CHEMICAL 6]

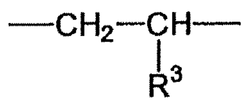

(where in the formula, $R^3$ is $-OR^4$, $-COOR^4$, or $-OCOR^4$ (provided that $R^4$ is an alkyl group)). $R^4$ is, for example, a straight-chain, branched chain, or cyclic alkyl group having 1 to 8 carbon atoms. As examples thereof, for example, preferred are cyclohexyl vinyl ether unit, methyl vinyl ether unit, ethyl vinyl ether unit, propyl vinyl ether unit, n-butyl vinyl ether unit, isobutyl vinyl ether unit, vinyl acetate unit, vinyl propionate unit, vinyl butyrate unit, vinyl isobutyrate unit, vinyl pivalate unit, vinyl caproate unit, vinyl versatate unit, vinyl laurate unit, vinyl stearate unit, and vinyl cyclohexylcarboxylate unit. Further, from the viewpoints of excellent weather resistance, solubility, and inexpensiveness, preferred are vinyl versatate, vinyl laurate, vinyl stearate, vinyl cyclohexylcarboxylate, and vinyl acetate. Out of these, from the viewpoint of the chemical resistance, preferred are non-aromatic type carboxylic acid vinyl esters, particularly, carboxylic acid vinyl esters in which carboxylic acid has 6 or more carbon atoms, and further preferably, carboxylic acid vinyl esters in which carboxylic acid has 9 or more carbon atoms. The upper limit of the number of carbon atoms of carboxylic acid in carboxylic acid vinyl ester is 20 or less, and further preferably 15 or less. As specific example thereof, vinyl versatate is most preferable.

The hydroxyl group-containing fluorinated copolymer (A-1) may contain a carboxyl group-containing monomer unit.

The carboxyl group-containing monomer unit contains a carboxyl group, and does not contain a hydroxyl group and an aromatic group. In this respect, it is different from other units. When the carboxyl group-containing monomer unit is prepared into a curable resin composition, it has an action of improving the dispersibility and the curing reactivity of the hydroxyl group-containing fluorinated copolymer (A-1), and improving the gloss, hardness, adhesion to the base material, and the like of the resulting coating film.

Examples of the carboxyl group-containing monomer unit may include carboxyl group-containing vinyl monomers represented by the following formula:

[CHEMICAL 7]

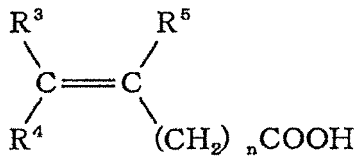

(where in the formula, $R^3$, $R^4$, and $R^5$ are the same or different, and each is a hydrogen atom, an alkyl group, a carboxyl group, or an ester group, and n is 0 or 1), or the following formula:

[CHEMICAL 8]

$$CH_2{=}CH{-}(CH_2)_n{-}(O{-}R^6OCO)_m R^7COOH$$

(where in the formula, $R^6$ and $R^7$ are the same or different, and each is a saturated or unsaturated straight-chain or cyclic alkyl group, n is 0 or 1, and m is 0 or 1).

Specific examples thereof may include one, or two or more of, for example, acrylic acid, methacrylic acid, vinyl acetate, crotonic acid, cinnamic acid, 3-allyloxy propionic acid, itaconic acid, itaconic acid monoester, maleic acid, maleic acid monoester, maleic anhydride, fumaric acid, fumaric acid monoester, vinyl phthalate, and vinyl pyromellitate. Out of these, preferred are crotonic acid, itaconic acid, maleic acid, maleic acid monoester, fumaric acid, fumaric acid monoester, and 3-allyloxy propionic acid with low homopolymerizability.

The lower limit of the ratio of the carboxyl group-containing monomer units is 0.1 mol%, and preferably 0.4 mol%. The upper limit thereof is 2.0 mol%, and preferably 1. 5 mol%. A ratio of more than 2.0 mol% is not preferable from the viewpoint of the curing speed of the coating film.

Specific examples of the hydroxyl group-containing fluorinated copolymer (A-1) may include:

[CHEMICAL 9]

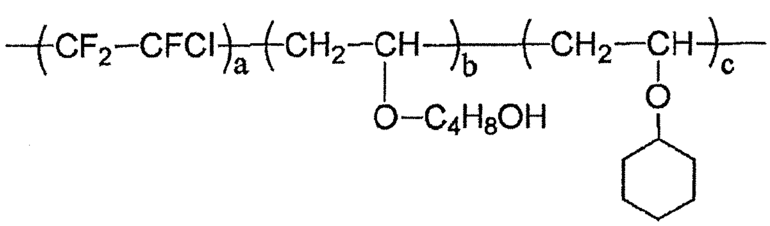

(where in the formula, the ratio of a, b, and c is, by mole ratio, a:b:c = 40 to 60 : 3 to 15 : 5 to 45);

[CHEMICAL 10]

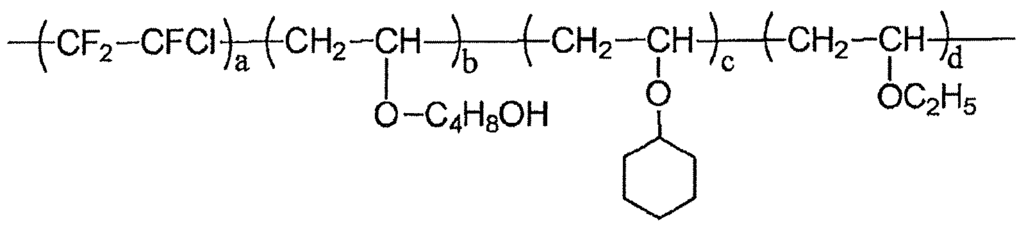

(where in the formula, the ratio of a, b, c, and d is, by mole ratio, a:b:c:d = 40 to 60 : 3 to 15 : 5 to 45 : 5 to 45);

[CHEMICAL 11]

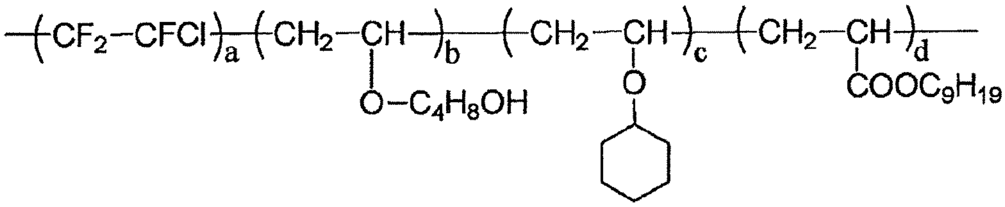

(where in the formula, the ratio of a, b, c and d is, by mole ratio, a:b:c:d = 40 to 60 : 3 to 15 : 5 to 45 : 5 to 45);

[CHEMICAL 12]

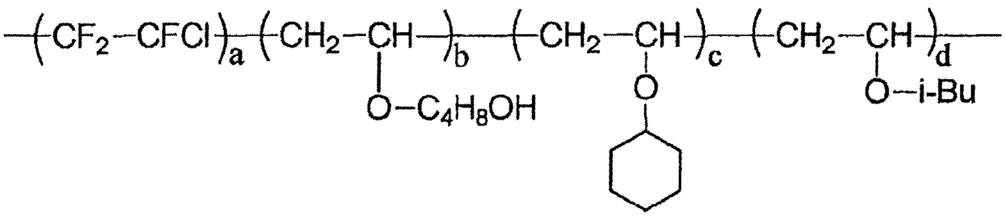

(where in the formula, the ratio of a, b, c and d is, by mole ratio, a:b:c:d = 40 to 60 : 3 to 15 : 5 to 45 : 5 to 45, and i-Bu means an isobutyl group); tetrafluoroethylene/vinyl versatate/hydroxybutyl vinyl ether; tetrafluoroethylene/vinyl versatate/hydroxyethyl vinyl ether/tert-butyl vinyl benzoate; tetrafluoroethylene/vinyl versatate/hydroxybutyl vinyl ether/crotonic acid; and tetrafluoroethylene/vinyl versatate/hydroxyethyl vinyl ether/vinyl benzoate/crotonic acid.

As the radical-polymerizable unsaturated groups in the isocyanate group-containing unsaturated compound (A-2), mention may be made of a methacryl group, an acryl group, a 2-fluoroacryl group, and a 2-chloroacryl group. From the viewpoints of the polymerization reactivity, the cost, and the ease of synthesis, a methacryl group and an acryl group are preferable, and especially an acryl group is most preferable.

Examples of the isocyanate group-containing unsaturated compound (A-2) may include alkyl vinyl ether and alkyl allyl ether represented by the following formula:

[CHEMICAL 13]

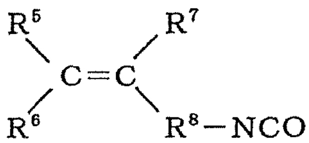

(where in the formula, $R^5$, $R^6$, or $R^7$ may be the same or different, and each is a hydrogen atom, a fluorine atom, a chlorine atom, or an alkyl group having 1 to 4 carbon atoms, and $R^8$ is $-COO-R^9-$, $-OCO-R^9-$, or $-O-R^9-$ (provided that $R^9$ is an a alkyl group having 1 to 20 carbon atoms)).

As the isocyanate group-containing unsaturated compound (A-2), 2-isocyanate ethyl acrylate represented by the following formula:

$CH_2=CHCO-O-CH_2-CH_2-NCO$ [CHEMICAL 14]

and 2-isocyanate ethyl methacrylate represented by the following formula:

[CHEMICAL 15]

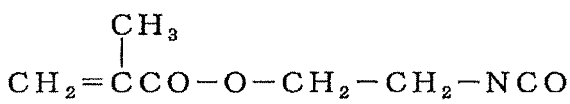

, 4-isocyanate butyl acrylate, and 4-isocyanate butyl methacrylate may be mentioned.

Further, mention may be made of those having one isocyanate group of the reaction products obtained by allowing unsaturated monoalcohol to react with polyhydric isocyanate. Examples of polyhydric isocyanate may include 2,4-tolylene diisocyanate, 2,6-tolylene diisocyanate, mixed isocyanate of 2,4-tolylene diisocyanate and 2,6-tolylene diisocyanate, P,P'-diphenylmethane diisocyanate, 1,5-naphthylene diisocyanate, paraphenylene diisocyanate, 1,6-hexamethylene diisocyanate, isophorone diisocyanate, and hydrogenated xylylene diisocyanate. Further, as unsaturated monoalcohols, mention may be made of monoalcohols having an acryloyl group or a methacryloyl group such as 2-hydroxyethyl acrylate, 2-hydroxyethyl methacrylate, 2-hydroxypropyl acrylate, 2-hydroxypropyl methacrylate, 4-hydroxybutyl acrylate, and 4-hydroxybutyl methacrylate, and monoalcohols having an allyl group such as allyl alcohol, allyl cellosolve, and trimethylpropane diallyl ether. Out of these, from the viewpoints of the ease of synthesis and the high reactivity, preferred are 2-isocyanate ethyl acrylate or 2-isocyanate ethyl methacrylate.

The reaction product (A) results from urethane bonding between the hydroxyl group in the hydroxyl group-containing fluorinated copolymer (A-1) and the isocyanate group in the isocyanate group-containing unsaturated compound (A-2).

The fluorine content of the reaction product (A) is preferably 2 mass% or more, more preferably 5 mass% or more, and further preferably 10 mass% or more from the viewpoints of the excellent weather resistance, water-repellent/oil-repellent property, and antifouling property. Further, the fluorine content of the reaction product (A) is preferably 50 mass% or less, further, more preferably 30 mass% or less, and further preferably 25 mass% or less from the viewpoint of the excellent solubility for an acrylic.

The molecular weight of the reaction product (A) is, by number-average molecular weight, preferably 1000 or more, more preferably 2000 or more, and further preferably 3000 or more from the viewpoints of the strength and the surface hardness of the cured product resulting from curing of a curable composition prepared therefrom. Further, the molecular weight of the reaction product (A) is, by number-average molecular weight, preferably 100000 or less from the viewpoint that the viscosity increases, resulting in difficult handling, more preferably 50000 or less from the viewpoint that the solubility for an acrylic is excellent, and further preferably 30000 or less from the viewpoint that the viscosity of the composition is low, resulting in excellent handling.

The acrylic monomer (B) in the curable resin composition (VIII) denotes a monomer having one, or two or more acryloyl groups, methacryloyl groups, 2-fluoroacryloyl groups, or 2-chloroacryloyl groups, and denotes the one different from the isocyanate group-containing unsaturated compound (A-2) having a radical-polymerizable unsaturated group.

The radical-polymerizable unsaturated groups in the acrylic monomer (B) are preferably in a number of one from the viewpoint that the solubility of the hydroxyl group-containing fluorinated copolymer (A-1) is high, and that the viscosity is low; further, preferably in a number of two or more from the viewpoint that the strength of the cured product resulting from curing of a curable composition prepared therefrom is excellent; and further, more preferably in a number of three or more from the viewpoint that the curing speed of the curable composition is excellent.

As the acrylic monomers (B), specifically, mention may be made of: methacrylate monomers such as methyl methacrylate (MMA), methacrylic acid (MA), ethyl methacrylate (EMA), n-butyl methacrylate (nBMA), isobutyl methacrylate (iBMA), 2-ethylhexyl methacrylate, phenyl methacrylate, cyclohexyl methacrylate, 3-(trimethoxysilyl)propyl methacrylate (MSPM), 2-(phenylphosphoryl)ethyl methacrylate (phenyl-P), 2,2-bis(4-methacryloxyphenyl)propane (BPDMA), 2,2-bis(4-methacryloxyethoxyphenyl)propane (Bis-MEPP), 2,2-bis(4-methacryloxypolyethoxyphenyl)propane (Bis-MPEPP), di(methacryloxyethyl)trimethyl hexamethylene diurethane (UDMA), trimethylolpropane trimethacrylate (TMPT), pentaerythritol triacrylate, pentaerythritol tetraacrylate, dipentaerythritol hexaacrylate, ethylene glycol dimethacrylate (EDMA or 1G), diethylene glycol dimethacrylate (DiEDMA), triethylene glycol dimethacrylate (TriEDMA), 1,4-butanediol dimethacrylate (1,4-BuDMA), 1,3-butanediol dimethacrylate (1,3-BuDMA), and 1,6-hexanediol diacrylate ($16HZ^6$); and hydroxyl group-containing methacrylate monomers such as 2-hydroxyethyl methacrylate (HEMA), 2-hydroxy-3-(β-naphthoxy)propyl methacrylate (HNPM), N-phenyl-N-(2-hydroxy-3-methacryloxy)propyl glycine (NPG-GMA), and 2,2-bis[4-(2-hydroxy-3-methacryloxypropoxy)phenyl]propane (Bis-GMA), and the like. Further, respective acrylates and respective 2-chloroacrylates corresponding to these can be exemplified.

Further, examples of the fluorinated acrylic monomers may include:

2-fluoroacrylates corresponding to the methacrylate monomers or the hydroxyl group-containing methacrylate monomers,
$CH_2=C(CH_3)COOCH_2CF_3$ (3FMA),
$CH_2=C(CH_3)COOCH_2CF_2CF_2H$ (4FMA),
$CH_2=C(CH_3)COOCH_2CF_2CF_3$ (5FMA),
$CH_2=C(CH_3)COOCH_2CF_2CFHCF_3$ (6FMA),
$CH_2=C(CH_3)COOCH_2(CF_2)_3CF_2H$ (8FMA),
$CH_2=C(CH_3)COOCH_2CH_2(CF_2)_3CF_3$ (9FMA),
$CH_2=C(CH_3)COOCH_2(CF_2)_5CF_2H$ (12FMA),

$CH_2$=C ($CH_3$) $COOCH_2CH_2(CF_2)_5CF_3$ (13FMA),
$CH_2$=C ($CH_3$) $COOCH_2CH_2(CF_2)_7CF_3$ (17FMA),
$CH_2$=C ($CH_3$) $COOCH(CF_3)_2$ (HFIP-MA),
$CH_2$=$C(CH_3)COOCH_2CCH_3(CF_3)_2$ (6FNP-MA), and
$CH_2$=C ($CH_3$) $COOCH_2CF(CF_3)$ $OCF_2CF_2CF_3$ (6FOn1-MA); and respective acrylates, respective 2-fluoroacrylates, and respective 2-chloroacrylates corresponding to these.

Examples of the 2-fluoroacrylate may include:

$CH_2$=$CFCOOCH_2CF_2CF_2H$ (4FFA),
$CH_2$=$CFCOOCH_2CF_2CF_3$ (5FFA),
$CH_2$=$CFCOOCH_2(CF_2)_3CF_2H$ (8FFA),
$CH_2$=$CFCOOCH_2(CF_2)_5CF_2H$ (12FFA), and
$CH_2$=CFCOOCH $(CF_3)_2$ (HFIP-FA).

Further, use of an acrylic monomer having a curable functional group provides a cured product excellent in adhesion, chemical resistance, curability, and the like, and hence is preferable. Examples of the acrylic monomer having a curable functional group may include acrylic monomers having a hydroxyl group, a carboxyl group, an epoxy group, an amino group, and the like. Although specific examples thereof correspond to the specific examples mentioned previously, examples thereof may include curable functional group-containing acrylic monomers such as hydroxyethyl (meth)acrylate, 2-hydroxypropyl (meth)acrylate, 2-hydroxyethyl vinyl ether, (meth)acrylic acid, glycidyl (meth)acrylate, 2-aminoethyl (meth)acrylate, and 2-aminopropyl (meth)acrylate.

The foregoing acrylic monomers can be mentioned, and from the viewpoint that the solubilities for the hydroxyl group-containing fluorinated copolymer (A-1), the isocyanate group-containing unsaturated compound (A-2), and the reaction product thereof (A) are excellent, preferred are methyl methacrylate, ethyl methacrylate, methyl acrylate, and ethyl acrylate.

The mass ratio of the reaction product (A) and the acrylic monomer (B) is preferably 95:5 to 5:95, more preferably 80:20 to 20:80, and further preferably 70:30 to 30:70. When the mass ratio of the reaction product (A) and the acrylic monomer (B) deviates from 95:5, and the reaction product (A) increases in mass, the reaction product (A) tends to increase in viscosity, and to become difficult to handle. Whereas, when the mass ratio of the reaction product (A) and the acrylic monomer (B) deviates from 5:95, and the reaction product (A) decreases in mass, the fluorine content is reduced. Accordingly, the cured product resulting from curing of the curable composition tends to be reduced in weather resistance, water-repellent/oil-repellent property, and antifouling property.

For the ratio of the reaction product (A) and the acrylic monomer (B), from another viewpoint, per 100 parts by mass of the reaction product (A), the acrylic monomer (B) is in a ratio of preferably 10 parts by mass or more, more preferably 40 parts by mass or more, and further preferably 60 parts by mass or more. When the acrylic monomer (B) decreases in amount, it tends to be high in viscosity and to become difficult to handle. Whereas, per 100 parts by mass of the reaction product (A), the acrylic monomer (B) is in a ratio of preferably 1500 parts by mass or less, more preferably 1200 parts by mass or less, and further preferably 1000 parts by mass or less. An increase in amount of the acrylic monomer (B) results in reduction of the fluorine content. Accordingly, the cured product resulting from curing of the curable composition tends to be reduced in weather resistance, water-repellent/oil-repellent property, and antifouling property.

The viscosity at 25°C of the curable resin composition is preferably 5 mPa·s or more because too low viscosity results in much dripping, which rather reduces the handling property. From the viewpoint that the thin film formability is excellent, the viscosity is more preferably 10 mPa·s or more. From the viewpoint that curing shrinkage during curing is small, the viscosity is further preferably 50 mPa·s or more. Further, the viscosity at 25°C of the curable resin composition is, from the viewpoint that the handling property is excellent, preferably 100000 mPa·s or less. From the viewpoint that during molding processing, the curable composition spreads therethroughout, the viscosity is more preferably 5000 mPa·s or less. From the viewpoint that when a thin film is formed, levelling (surface smoothness) property is excellent, the viscosity is further preferably 3000 mPa·s or less.

The curable resin composition may further contain a curing agent. The curing agent is a compound which reacts with the curing reactive group of the hydroxyl group-containing fluorinated copolymer (A-1) for crosslinking. For example, there are commonly used isocyanates not having an unsaturated bond, amino resins, acid anhydrides, polyepoxy compounds, and isocyanate group-containing silane compounds.

Specific examples of the isocyanates not having an unsaturated bond may include, but are not limited to: 2,4-tolylene diisocyanate, diphenylmethane-4,4'-diisocyanate, xylylene diisocyanate, isophorone diisocyanate, lysine methyl ester diisocyanate, methylcyclohexyl diisocyanate, trimethyl hexamethylene diisocyanate, hexamethylene diisocyanate, and n-pentane-1,4-diisocyanate or trimers thereof, adduct forms thereof, biuret form thereof, polymers thereof having

two, or more isocyanate groups, and further blocked isocyanates.

Specific examples of the amino resins may include, but are not limited to: other than urea resin, melamine resin, benzoguanamine resin, and glycoluril resin, methylolated melamine resin obtained by methylolating melamine, and alkyl etherified melamine resin obtained by etherifying methylolated melamine with alcohols such as methanol, ethanol, and butanol.

Specific examples of the acid anhydrides may include, but are not limited to: phthalic anhydride, pyromellitic anhydride, and mellitic anhydride.

As the polyepoxy compounds and the isocyanate group-containing silane compounds, there can be used, for example, those described in JP-A H2-232250, JP-A H2-232251, and the like. As preferable examples, for example

[CHEMICAL 16]

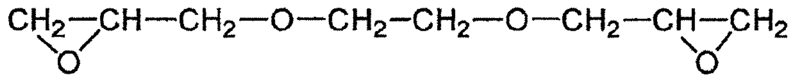

,

[CHEMICAL 17]

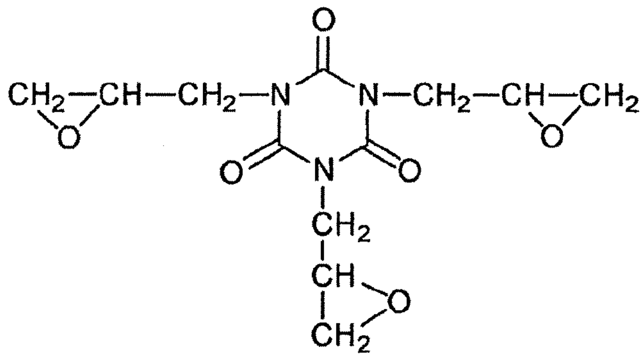

,

[CHEMICAL 18]

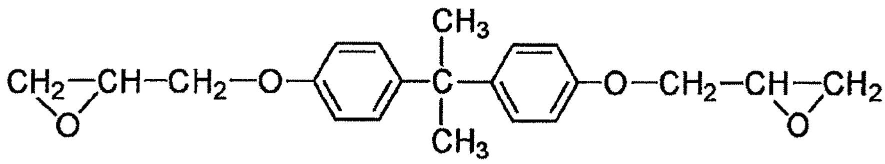

,

$OCNC_3H_6Si(OC_2H_5)_3$, and $OCNC_2H_4Si(OCH_3)_3$ may be mentioned.

The mixing amount of the curing agent is 0.1 to 5 equivalents, and preferably 0.5 to 1.5 equivalents per equivalent of the chemically curing reactive group in the hydroxyl group-containing fluorinated copolymer (A-1). The composition of the present invention can generally be cured for several minutes to about 10 days at 0 to 200°C.

Further, for curing the curable resin composition, curing is caused by UV irradiation for polymerizing the reaction product (A) and the acrylic monomer (B). For this reason, the curable resin composition may contain therein a photopolymerization initiator. Specific examples of the photopolymerization initiator may include: acetophenone type compounds such as acetophenone, chloroacetophenone, diethoxyacetophenone, hydroxyacetophenone, and α-aminoacetophenone; benzoin type compounds such as benzoin, benzoin methyl ether, benzoin ethyl ether, benzoin isopropyl ether, benzoin isobutyl ether, and benzyldimethyl ketal; benzophenone type compounds such as benzophenone, benzoylbenzoic acid, benzoyl methyl benzoate, 4-phenyl benzophenone, hydroxy benzophenone, hydroxy-propyl benzophenone, acrylated benzophenone, and Michler's ketone; thioxanthones such as thioxanthone, chlorothioxanthone, methyl thioxanthone, diethyl thioxanthone, and dimethyl thioxanthone; and as other compounds, benzyl, α-acyloxime ester, acyl phosphine oxide, glyoxy ester, 3-ketocumarine, 2-ethyl anthraquinone, camphorquinone, and anthraquinone.

Further, if required, known photoinitiator aids such as amines, sulfones, and sulfines may be added.

The curable resin composition does not contain an organic solvent not having a radical reactive group and a fluorine type solvent. This is preferable in that the step of removing the solvent after curing the curable resin composition is unnecessary, and in that there are no adverse effects such as reduction of the heat resistance, reduction of the strength, and cloudiness due to the residual solvents.

The curing catalysts may be used alone, or may be used in combination of two or more thereof. As preferable

curing catalysts, mention may be made of organotin compounds and aluminum chelate compounds.

Further, mention may be made of acidic phosphoric acid esters, reaction products of acidic phosphoric acid esters and amines, saturated or unsaturated polyhydric carboxylic acids or acid anhydrides thereof, organic titanate compounds, amine type compounds, lead octylate, and the like.

Specific examples of the organotin compounds may include dibutyltin dilaurate, dibutyltin maleate, dioctyltin maleate, dibutyltin diacetate, dibutyltin phthalate, tin octylate, tin naphthenate, and dibutyltin methoxide.

Further, the acidic phosphoric acid ester is phosphoric acid ester containing the moiety represented by,

[CHEMICAL 19]

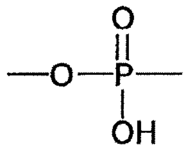

and for example, mention may be made of organic acidic phosphoric acid esters represented by:

[CHEMICAL 20]

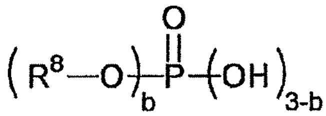

(where b denotes 1 or 2, and $R^8$ denotes an organic residue). Specifically,

[CHEMICAL 21]

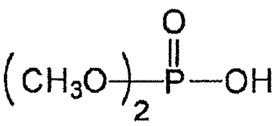 、 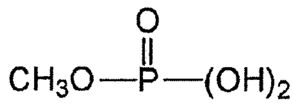 、 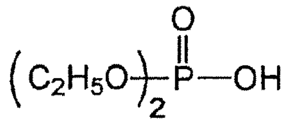 、

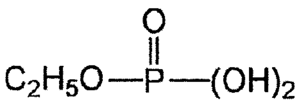 、 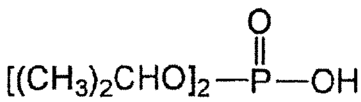

and the like may be mentioned.

Examples of the organic titanate compounds may include titanium acid esters such as tetrabutyl titanate, tetraisopropyl titanate, and triethanolamine titanate.

Further, specific examples of the amine type compounds may include: amine type compounds such as butylamine, octylamine, dibutylamine, monoethanolamine, diethanolamine, triethanolamine, diethylenetriamine, triethylenetetramine, oleylamine, cyclohexylamine, benzylamine, diethylaminopropylamine, xylylene diamine, triethylenediamine, guanidine, diphenyl guanidine, 2,4,6-tris(dimethylaminomethyl)phenol, morpholine, N-methylmorpholine, and 1,8-diazabicyclo(5.4.0)undecene-7(DBU), further, salts thereof with carboxylic acid and the like, low-molecular-weight polyamide resins resulting from excess polyamines and polybasic acids, and reaction products of excess polyamines and epoxy compounds.

The curing catalysts may be used alone, or may be used in combination of two or more thereof. The mixing ratio of the curing promoter is preferably $1.0 \times 10^{-6}$ to $1.0 \times 10^{-2}$ parts by mass, and more preferably $5.0 \times 10^{-5}$ to $1.0 \times 10^{-3}$ parts by mass per 100 parts by mass of the copolymer.

The mixing ratio of the weather resistant organic material and the organometallic compound varies according to the purpose and the intended use. Generally, the organometallic compound is in a ratio of 0.1 to 50 parts by mass, and preferably 1 to 30 parts by mass per 100 parts by mass of the weather resistant organic material. When the ratio is less than 0.1 part by mass, the hydrophilization action tends to become insufficient. When the ratio exceeds 50 parts by mass, a defective outward appearance and reduction of the compatibility with resins tend to be caused.

Further, as the weather resistant organic materials, other than these, the following curable resin compositions (IX) can also be used. The curable resin composition (IX) contains (A) a reaction product of a hydroxyl group-containing fluorinated polymer (A-1) containing a radical-polymerizable unsaturated monomer unit containing a fluorine atom and a hydroxyl group, and an isocyanate group-containing unsaturated compound (A-2) having one isocyanate group and at least one radical-polymerizable unsaturated group, and (B) an acrylic monomer.

Specific examples of the hydroxyl group-containing radical-polymerizable unsaturated monomer unit in the hydroxyl group-containing fluorinated copolymer (A-1) may include hydroxyl group-containing fluorinated ethylenic monomers represented by the formula (I):

[CHEMICAL 22]

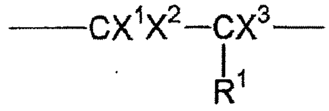

(I)

(where in the formula, $X^1$ and $X^2$ may be the same or different, and each is a fluorine atom or a hydrogen atom; $X^3$ is a fluorine atom, a hydrogen atom, a chlorine atom, a methyl group, or a trifluoromethyl group; $R^1$ is a chain or branched chain alkyl group, fluoroalkyl group, or perfluoroalkyl group having 1 to 30 carbon atoms, and containing at least one or more hydroxyl groups, and may contain, in the chain, an ether bond, an ester bond, or an urethane bond; provided that at least one fluorine atom is contained in any of $X^1$ to $X^3$, and $R^1$). Out of these, hydroxyl group-containing fluorinated ethylenic monomers represented by the formula (II) are more preferable.

[CHEMICAL 23]

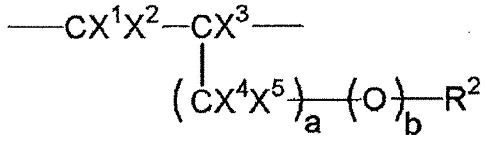

(II)

(where in the formula, $X^1$ and $X^2$ may be the same or different, and each is a fluorine atom or a hydrogen atom; $X^3$ is a fluorine atom, a hydrogen atom, a chlorine atom, a methyl group, or a trifluoromethyl group; $X^4$ and $X^5$ may be the same or different, and each is a hydrogen atom, a fluorine atom, a methyl group, or a trifluoromethyl group; a is an integer of 0 to 3; b is 0 or 1; and $R^2$ is a chain or branched chain alkyl group, fluoroalkyl group, or perfluoroalkyl group having 1 to 29 carbon atoms, and containing at least one or more hydroxyl groups, and may contain, in the chain, an ether bond, an ester bond, or an urethane bond; provided that at least one fluorine atom is contained in any of $X^1$ to $X^5$ and $R^2$).

Further preferable hydroxyl group-containing fluorinated ethylenic monomer is represented by the formula (III):

[CHEMICAL 24]

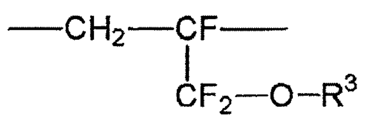

(III)

(where in the formula, $R^3$ is a chain or branched chain alkyl group, fluoroalkyl group, or perfluoroalkyl group having 1 to 29 carbon atoms, and containing at least one or more hydroxyl groups, and may contain, in the chain, an ether bond, an ester bond, or an urethane bond).

Then, the hydroxyl group contained in $R^1$ to $R^3$ will be described. The carbon atoms to each of which a hydroxyl group is directly bonded can be generally classified into three kinds of primary carbons, secondary carbons, and tertiary carbons according to the number of carbon atoms bonded to the carbon atom to which a hydroxyl group is bonded.

First, the primary carbon is that in the case where the number of carbon atoms bonded to the carbon atom to which a hydroxyl group is bonded is one as with $R-CH_2-OH$ (where R is an organic group having one or more carbon atoms).

Specifically, as monovalent hydroxyl group-containing organic groups,

[CHEMICAL 25]

$-CH_2OH$ 、 $-CH_2CH_2OH$ 、

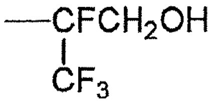 、 $-CF_2CH_2OH$

and the like may be mentioned.

Then, the secondary carbon is that in the case where the number of carbon atoms bonded to the carbon to which a hydroxyl group is bonded is 2 as with R-CR' H-OH, (where R and R' are each an organic group having one or more carbon atoms).

Specifically, as the monovalent hydroxyl group-containing organic groups,

[CHEMICAL 26]

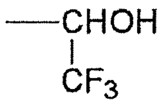 、 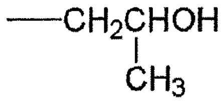 、

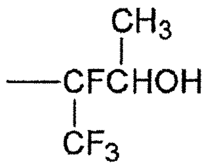 、 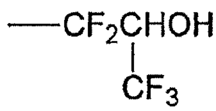

and the like may be mentioned.

Then, the tertiary carbon is that where the number of carbon atoms bonded to the carbon to which a hydroxyl group is bonded is 3 as with R-CR'R''-OH (where R, R', and R'' are each an organic group having one or more carbon atoms). Specifically, as the monovalent hydroxyl group-containing organic groups,

[CHEMICAL 27]

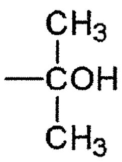 、 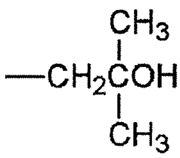 、 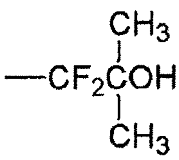 、

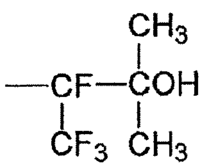 、 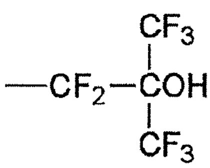 、 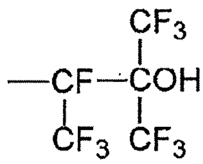

and the like may be mentioned.

Out of these, preferred are, from the viewpoint of steric hindrance, the hydroxyl group bonded to the primary and secondary carbons, and from the viewpoint of the reactivity, preferably, the hydroxyl group bonded to the primary carbon.

Then, with a monovalent hydroxyl group-containing organic group having 1 to 10 carbon atoms and having a hydroxyl group bonded to the primary to tertiary carbons as described above as $Y^1$, specific structures of $R^1$ to $R^3$ will be described using Y. Herein, Y represents $Y^1$ or simply a hydroxyl group.

[CHEMICAL 28]

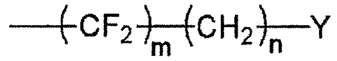 、

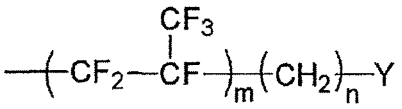 、

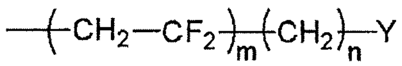 、

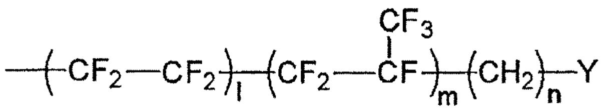 、

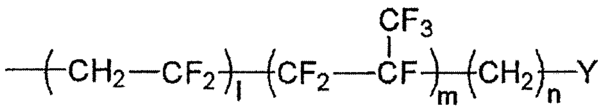 、

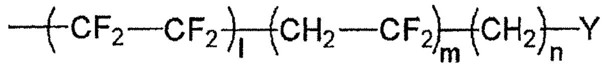 、

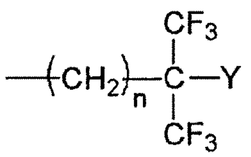 、

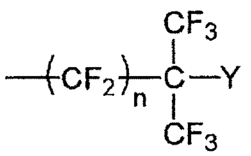 、

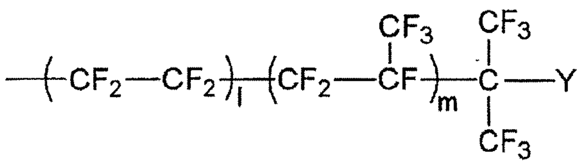 .

(where l, m and n are each an integer, l is 1 to 10, m is 1 to 10, and n is 1 to 5)

[CHEMICAL 29]

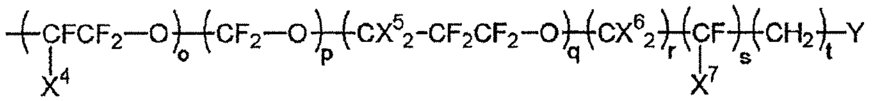

、

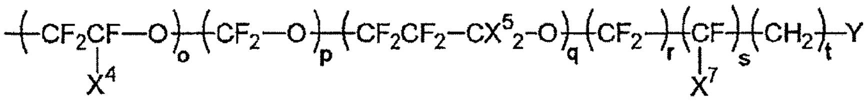

(where in the formula, $X^4$ and $X^7$ are each F or $CF_3$, $X^5$ and $X^6$ are each H or F, o+p+q is 1 to 10; r is 0 or 1; and s and t are each 0 or 1), and the like may be mentioned.

As specific examples of the formula (III),

[CHEMICAL 30]

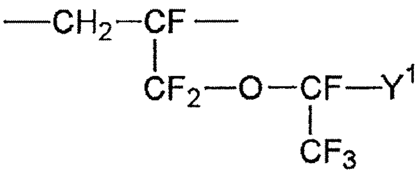

、

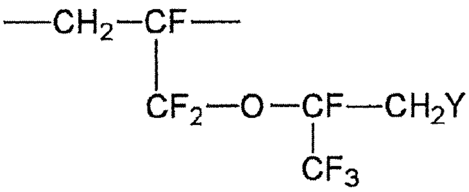

、

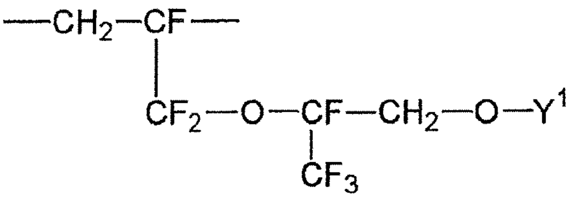

、

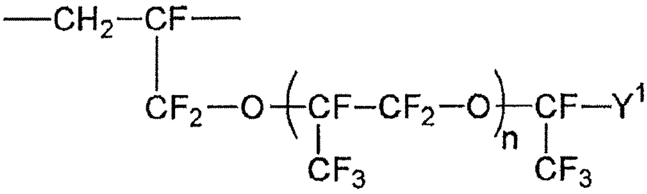

、

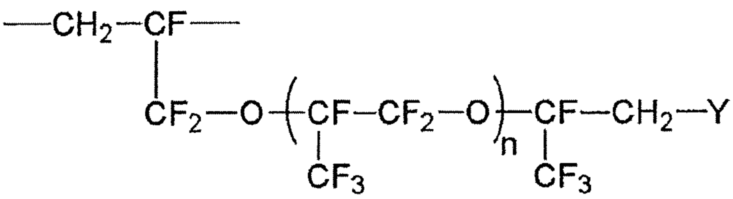

、

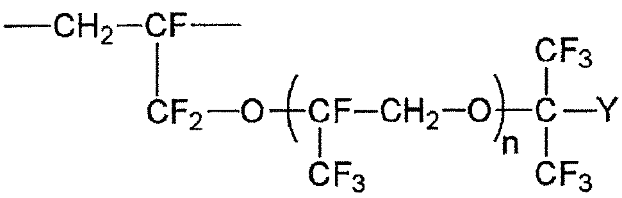

、

[CHEMICAL 31]

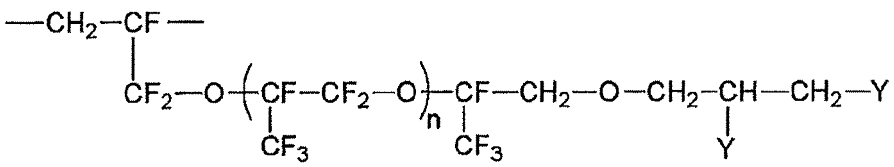

、

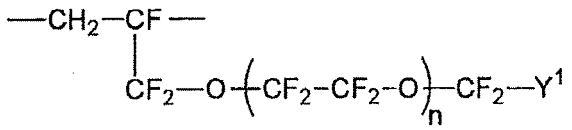

、

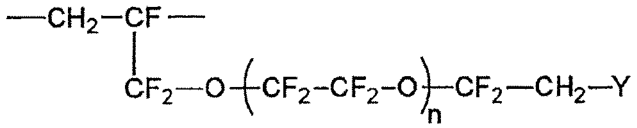

、

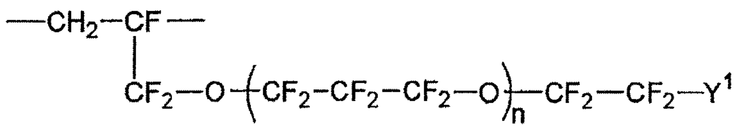

、

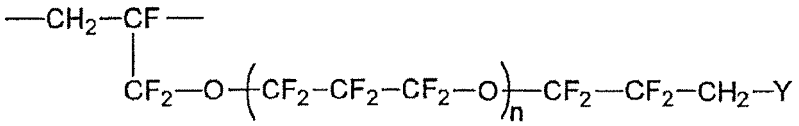

、

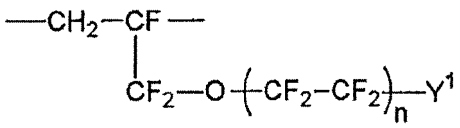

、

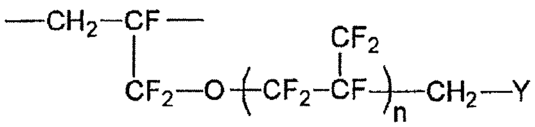

and further particularly,

[CHEMICAL 32]

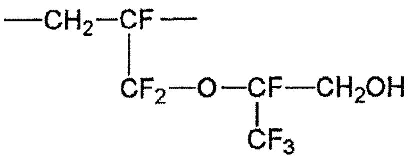

、

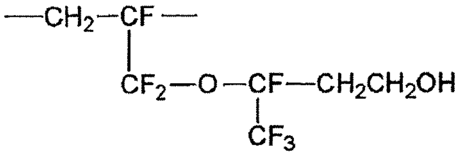

、

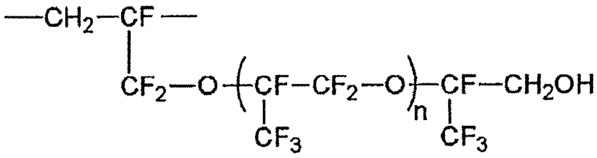

、

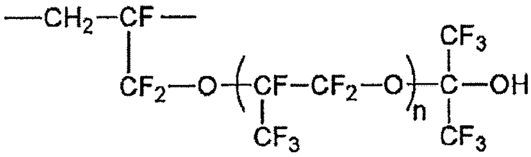

、

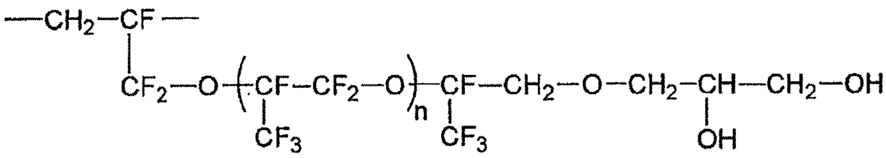

、

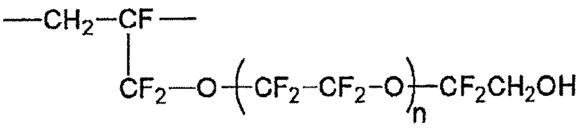

、

[CHEMICAL 33]

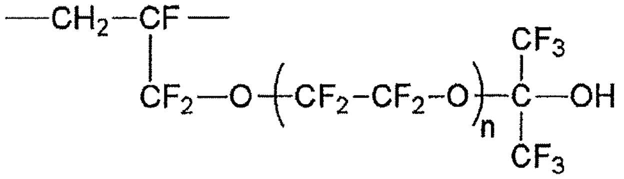

、

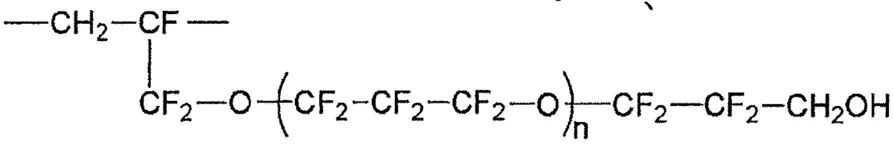

、

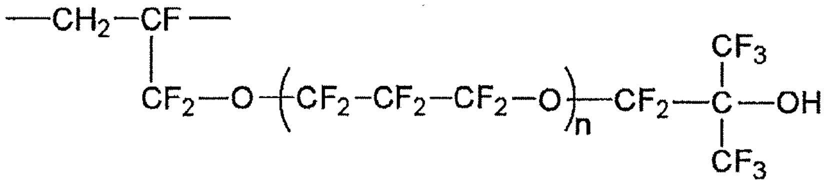

、

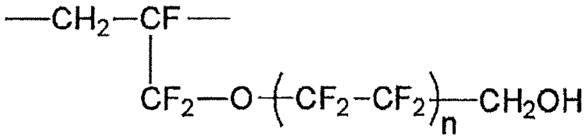

、

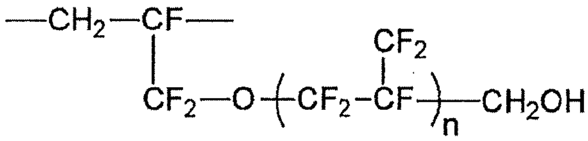

、

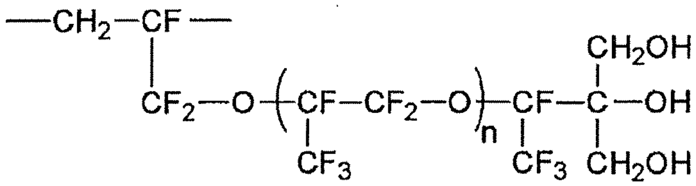

、

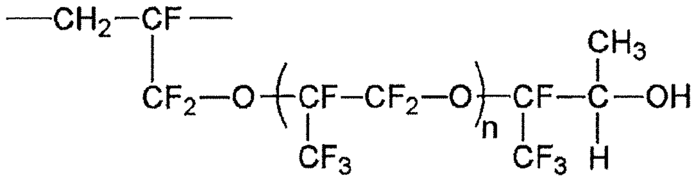

and the like may be mentioned.

Out of these, from the viewpoints of the solubility for an acrylic monomer, and the reactivity with an isocyanate group (-NCO),

[CHEMICAL 34]

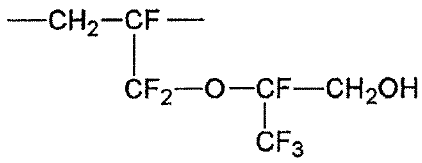

、

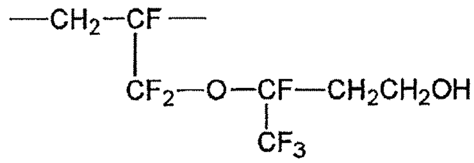

、

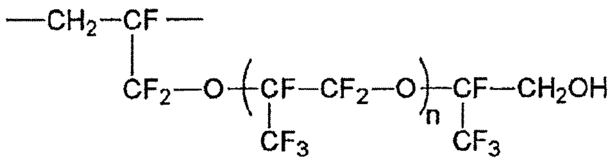

、

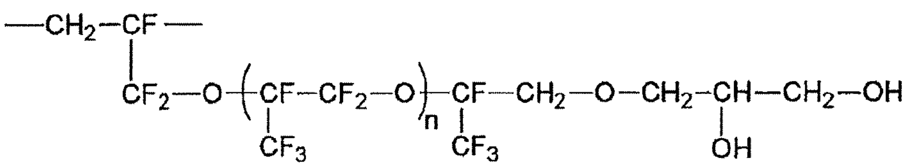

are in particular preferred.

The hydroxyl group-containing fluorinated polymer may further contain a monomer unit not containing a hydroxyl group in the structural unit in such a range as not to impair the solubility for an acrylic. For the specific examples of such a monomer unit, there can be adopted all those not having a hydroxyl group in the structural units A and M described in WO02/18457.

Out of these, from the viewpoint of the solubility for acrylic monomers, particularly,

$-CH_2-CF_2-$,

$-CH_2-CF(CF_3)-$,

[CHEMICAL 35]

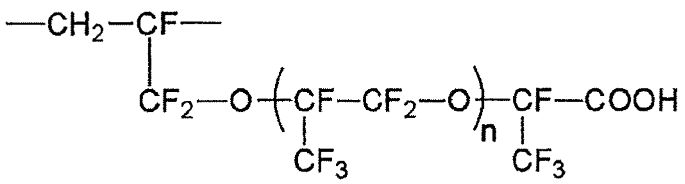

、

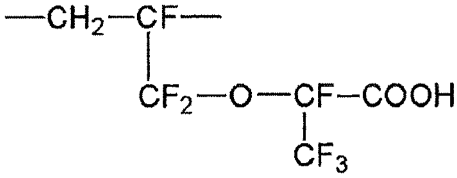

、

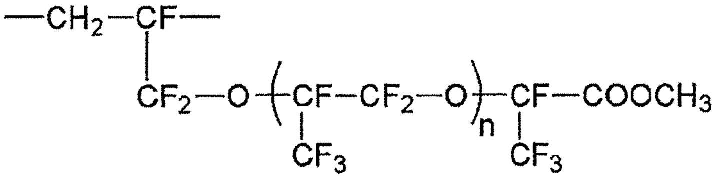

、

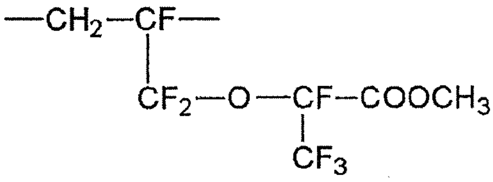

are preferable.

As specific hydroxyl group-containing fluorinated polymers, from the viewpoints of the solubility for acrylic monomers, and the reactivity with NCO,

[CHEMICAL 36]

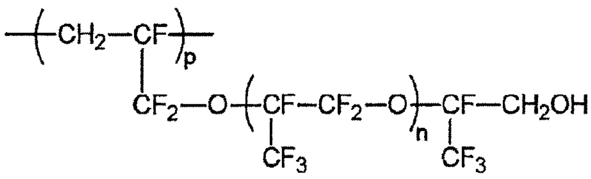

、

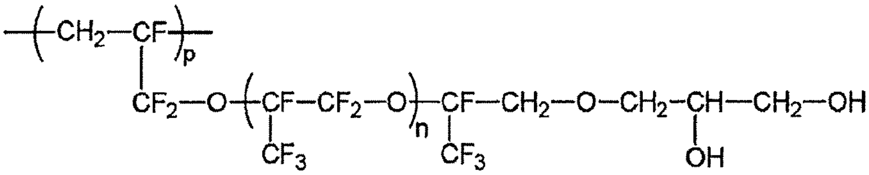

、

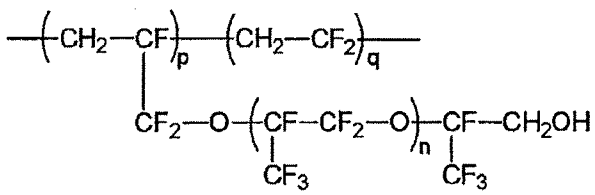

、

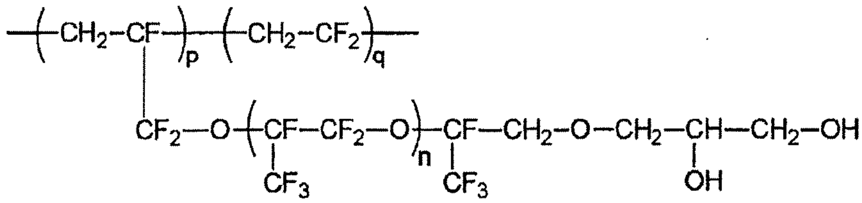

、

[CHEMICAL 37]

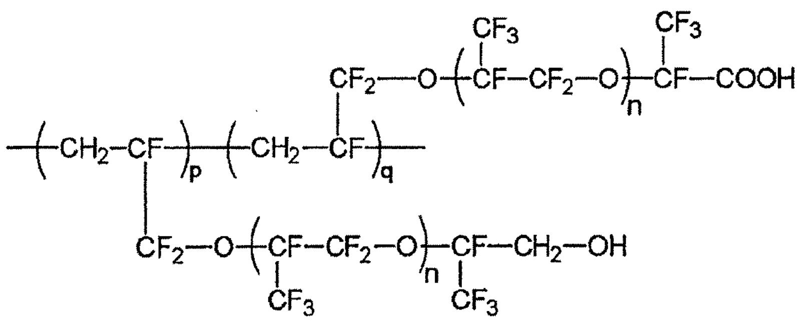

、

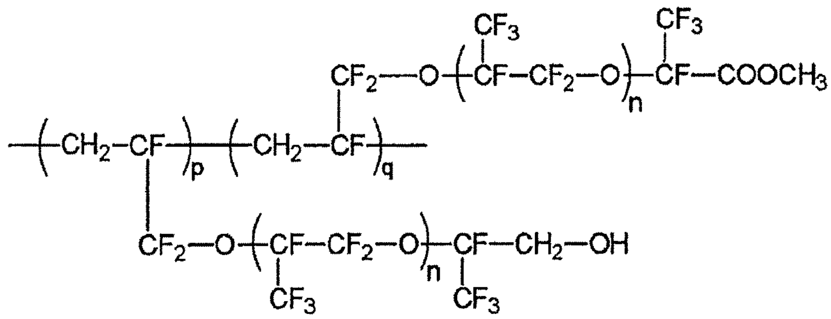

、

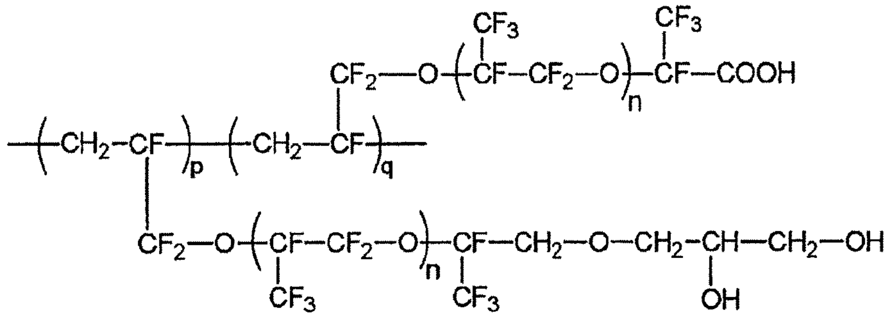

、

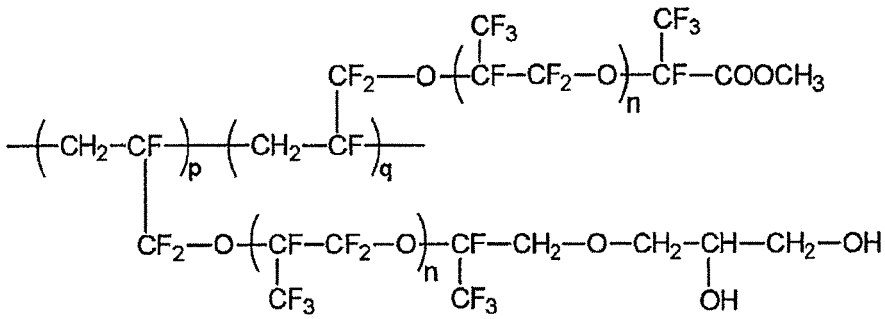

(where in the formula, the ratio of p and q is, by mole ratio, 20/80 to 99/1), and the like may be mentioned.

As the radical-polymerizable unsaturated groups in the isocyanate group-containing unsaturated compound (A-2), mention may be made of a methacryl group, an acryl group, a 2-fluoroacryl group, and a 2-chloroacryl group. From the viewpoints of the polymerization reactivity, the cost, and the ease of synthesis, a methacryl group and an acryl group are preferable, and especially, an acryl group is in particular preferable.

As the isocyanate group-containing unsaturated compounds (A-2), for example, alkyl vinyl ether and alkyl allyl ether represented by the formula (IV):

[CHEMICAL 38]

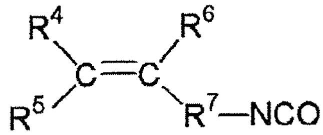

(IV)

(where in the formula, $R^4$, $R^5$, or $R^6$ may be the same or different, and is a hydrogen atom, a fluorine atom, a chlorine atom, or a alkyl group having 1 to 4 carbon atoms, and $R^7$ is $-COO-R^8-$, $-OCO-R^8$, or $-O-R^8-$ (provided that $R^8$ is an alkyl group having 1 to 20 carbon atoms)) may be mentioned.

As the isocyanate group-containing unsaturated compounds (A-2), for example, 2-isocyanate ethyl acrylate represented by the formula (V):

$$CH_2=CHCOOCH_2CH_2NCO \qquad (V)$$

2-isocyanate ethyl methacrylate represented by the formula (VI) :

$$CH_2=C(CH_3)COOCH_2CH_2NCO \qquad (VI)$$

the compound represented by the formula (VII):

[CHEMICAL 39]

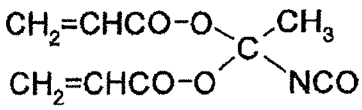

(VII) 、

4-isocyanate butyl acrylate, and 4-isocyanate butyl methacrylate may be mentioned.

Further, out of the reaction products obtained by allowing unsaturated monoalcohols to react with polyhydric isocyanates, those having one isocyanate group may be mentioned. Examples of polyhydric isocyanates may include: 2,4-tolylene diisocyanate, 2,6-tolylene diisocyanate, mixed isocyante of 2,4-tolylene diisocyanate and 2,6-tolylene diisocyanate, P,P'-diphenylmethane diisocyanate, 1,5-naphthylene diisocyanate, paraphenylene diisocyanate, 1,6-hexamethylene diisocyanate, isophorone diisocyanate, and hydrogenated xylylene diisocyanate. Further, as unsaturated monoalcohols, mention may be made of monoalcohols having an acryloyl group or a methacryloyl group such as 2-hydroxyethyl acrylate, 2-hydroxyethyl methacrylate, 2-hydroxypropyl acrylate, 2-hydroxypropyl methacrylate, 4-hydroxybutyl acrylate, and 4-hydroxybutyl methacrylate, and monoalcohols having an allyl group such as allyl alcohol, allyl cellosolve, and trimethylpropane diallyl ether. Out of these, from the viewpoints of the ease of synthesis and the high reactivity, 2-isocyanate ethyl acrylate or 2-isocyanate ethyl methacrylate is preferable.

The reaction product (A) results from urethane bonding between the hydroxyl group in the hydroxyl group-containing fluorinated polymer (A-1), and the isocyanate group in the isocyanate group-containing unsaturated compound (A-2).

The fluorine content of the reaction product (A) is preferably 20 mass% or more from the viewpoints that the weather resistance, the water-repellent/oil-repellent property, and the antifouling property are excellent. From the viewpoint that the transparency is excellent within a wide wavelength range from visible to near infrared region, the fluorine content is more preferably 40 mass% or more, and further preferably 50 mass% or more. Further, the fluorine content of the reaction product (A) is preferably 75 mass% or less, more preferably 70 mass% or less, and further preferably 65 mass% or less from the viewpoint that the solubility for an acrylic is excellent.

The molecular weight of the reaction product (A) is, by number-average molecular weight, preferably 1000 or more, more preferably 2000 or more, and further preferably 3000 or more from the viewpoints that the strength and the surface hardness of the cured product resulting from curing of a curable composition prepared therefrom are excellent. Further, the molecular weight of the reaction product (A) is, by number-average molecular weight, preferably 500000 or less from the viewpoints that the viscosity does not increase, resulting in excellent handling, more preferably 100000 or less from the viewpoint that the solubility for an acrylic is excellent, and further preferably 50000 or less from the viewpoints that the viscosity of the composition is low, resulting in excellent handling.

The acrylic monomer (B) in the curable resin composition (IX) denotes a monomer having one, or two or more of acryloyl groups, methacryloyl groups, 2-fluoroacryloyl groups, or 2-chloroacryloyl groups, and denotes the one different

from the isocyanate group-containing unsaturated compound (A-2) having a radical reactive group.

The radical-polymerizable unsaturated groups in the acrylic monomer (B) are preferably in a number of one from the viewpoint that the solubility of the hydroxyl group-containing fluorinated copolymer (A-1) is high, and that the viscosity is low; further, preferably in a number of two or more from the viewpoint that the strength of the cured product resulting from curing of a curable composition prepared therefrom is excellent; and further, more preferably in a number of three or more from the viewpoint that the curing speed of the curable composition is excellent.

As the acrylic monomer (B), specifically, mention may be made of: methyl methacrylate (MMA), methacrylic acid (MA), ethyl methacrylate (EMA), n-butyl methacrylate (nBMA), isobutyl methacrylate (iBMA), 2-ethylhexyl methacrylate, 2-hydroxyethyl methacrylate (HEMA), phenyl methacrylate, cyclohexyl methacrylate, 3-(trimethoxysilyl)propyl methacrylate (MSPM), 2-(phenylphosphoryl)ethyl methacrylate (phenyl-P), 2-hydroxy-3-(β-naphthoxy)propyl methacrylate (HNPM), N-phenyl-N-(2-hydroxy-3-methacryloxy)propyl glycine (NPG-GMA), ethylene glycol dimethacrylate (EDMA or 1G), diethylene glycol dimethacrylate (DiEDMA), triethylene glycol dimethacrylate (TriEDMA), 1,4-butanediol dimethacrylate (1,4-BuDMA), 1,3-butanediol dimethacrylate (1,3-BuDMA), 1,6-hexanediol diacrylate (16HX), 2,2-bis[4-(2-hydroxy-3-methacryloxypropoxy)phenyl]propane (Bis-GMA), 2,2-bis(4-methacryloxyphenyl)propane (BPDMA), 2,2-bis(4-methacryloxyethoxyphenyl)propane (Bis-MEPP), 2,2-bis(4-methacryloxypolyethoxy phenyl)propane (Bis-MPEPP), di(methacryloxyethyl)trimethyl hexamethylene diurethane (UDMA), trimethylolpropane trimethacrylate (TMPA), pentaerythritol triacrylate, pentaerythritol tetraacrylate, dipentaerythritol hexaacrylate (DPEHA), and the like. Further, respective acrylates, respective 2-fluoroacrylates, and respective 2-chloroacrylates corresponding to these can be exemplified.

Further, examples of the fluorinated acrylic monomers may include:

$CH_2$=$C(CH_3)COOCH_2CF_3$ (3FMA),
$CH_2$=$C(CH_3)COOCH_2CF_2CF_2H$ (4FMA),
$CH_2$=C ($CH_3$) $COOCH_2CF_2CF_3$ (5FMA),
$CH_2$=C ($CH_3$) $COOCH_2CF_2CFHCF_3$ (6FMA),
$CH_2$=C ($CH_3$) $COOCH_2(CF_2)_3CF_2H$ (8FMA),
$CH_2$=C ($CH_3$) $COOCH_2CH_2(CF_2)_3CF_3$(9FMA),
$CH_2$=C ($CH_3$) $COOCH_2(CF_2)_5CF_2H$ (12FMA),
$CH_2$=C ($CH_3$) $COOCH_2CH_2(CF_2)_5CF_3$ (13FMA),
$CH_2$=C ($CH_3$) $COOCH_2CH_2(CF_2)_7$CF3 (17FMA),
$CH_2$=C ($CH_3$) $COOCH(CF_3)_2$ (HFIP-MA),
$CH_2$=C ($CH_3$) $COOCH_2CCH_3(CF_3)_2$ (6FNP-MA), and
$CH_2$=C ($CH_3$) $COOCH_2CF(CF_3)OCF_2CF_2CF_3$ (6FOn1-MA),
and further, respective acrylates, respective 2-fluoroacrylates, and respective 2-chloroacrylates corresponding to these.

Examples the 2-fluoroacrylates may include:

$CH_2$=$CFCOOCH_2CF_2CF_2H$ (4FFA),
$CH_2$=$CFCOOCH_2CF_2CF_3$ (5FFA),
$CH_2$=$CFCOOCH_2(CF_2)_3CF_2H$ (8FFA),
$CH_2$=$CFCOOCH_2(CF_2)_5CF_2H$ (12FFA), and
$CH_2$=$CFCOOCH(CF_3)_2$ (HFIP-FA).

The foregoing acrylic monomers may be mentioned. From the viewpoint that the solubilities for the hydroxyl group-containing fluorinated polymer (A-1), the isocyanate group-containing unsaturated compound (A-2), and the reaction product thereof (A) are excellent, preferred are methyl methacrylate, ethyl methacrylate, methyl acrylate, and ethyl acrylate.

The mass ratio of the reaction product (A) and the acrylic monomer (B) is preferably 95:5 to 5:95, more preferably 80:20 to 20:80, and further preferably 70:30 to 30: 70. When the mass ratio of the reaction product (A) and the acrylic monomer (B) deviates from 95:5, and the reaction product (A) increases in mass, the reaction product (A) tends to increase in viscosity, and to become difficult to handle. Whereas, when the mass ratio of the reaction product (A) and the acrylic monomer (B) deviates from 5: 95, and the reaction product (A) decreases in mass, the fluorine content is reduced. Accordingly, the cured product resulting from curing of the curable composition tends to be reduced in weather resistance, water-repellent/oil-repellent property, and antifouling property.

The viscosity at 30°C of the curable resin composition is preferably 5 mPa·s or more because too low viscosity results in much dripping, which rather reduces the handling property. From the viewpoint that the thin film formability is excellent, the viscosity is more preferably 10 mPa·s or more. From the viewpoint that curing shrinkage during curing is

small, the viscosity is further preferably 50 mPa·s or more. Further, the viscosity at 30°C of the curable resin composition is, from the viewpoint that the handling property is excellent, preferably 100000 mPa·s or less. From the viewpoint that during molding processing, the curable composition spreads therethroughout, the viscosity is more preferably 50000 mPa·s or less. From the viewpoint that when a thin film is formed, levelling (surface smoothness) property is excellent, the viscosity is further preferably 20000 mPa·s or less.

The curable resin composition (IX) may further contain a curing agent. The curing agent is a compound which reacts with the curing reactive group of the hydroxyl group-containing fluorinated polymer (A-1) for crosslinking. For example, there are commonly used isocyanates not having an unsaturated bond, amino resins, acid anhydrides, polyepoxy compounds, and isocyanate group-containing silane compounds.

Specific examples of the isocyanates not having an unsaturated bond may include, but is not limited to: 2,4-tolylene diisocyanate, diphenylmethane-4,4'-diisocyanate, xylylene diisocyanate, isophorone diisocyanate, lysine methyl ester diisocyanate, methylcyclohexyl diisocyanate, trimethyl hexamethylene diisocyanate, hexamethylene diisocyanate, and n-pentane-1,4-diisocyanate or trimers thereof, adduct forms thereof, biuret form thereof, polymers thereof having two or more isocyanate groups, and further blocked isocyanates.

Specific examples of the amino resins may include, but are not limited to: other than urea resin, melamine resin, benzoguanamine resin, and glycoluril resin, methylolated melamine resin obtained by methylolating melamine, and alkyl etherified melamine resin obtained by etherifying methylolated melamine with alcohols such as methanol, ethanol, and butanol.

Specific examples of the acid anhydrides may include, but are not limited to: phthalic anhydride, pyromellitic anhydride, and mellitic anhydride.

As the polyepoxy compounds and the isocyanate group-containing silane compounds, there can be used, for example, those described in JP-A H2-232250, JP-A H2-232251, and the like. As preferable examples, for example

[CHEMICAL 40]

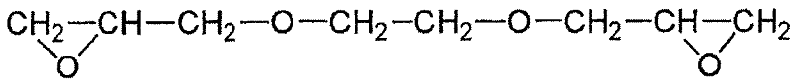
、

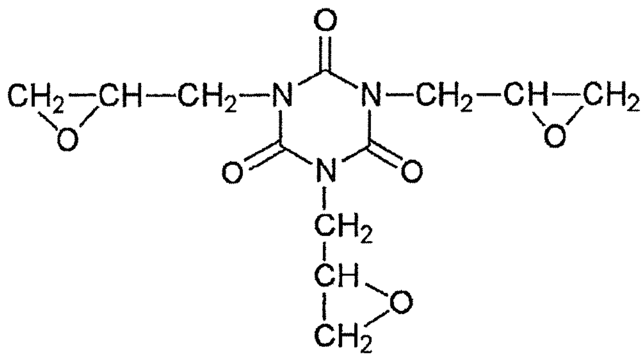
、

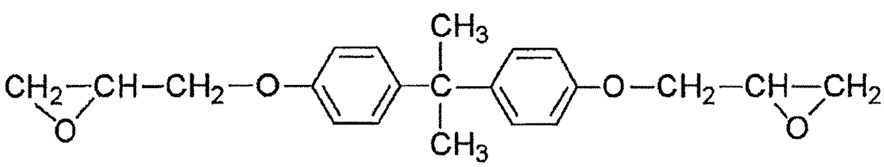
、

$OCNC_3H_6Si(OC_2H_5)_3$,

$OCNC_2H_4Si(OCH_3)_3$, and the like may be mentioned.

The mixing amount of the curing agent is 0.1 to 5 equivalents, and preferably 0.5 to 1.5 equivalents per equivalent of the chemically curing reactive group in the hydroxyl group-containing fluorinated polymer (A-1). The composition of the present invention can generally be cured for several minutes to about 10 days at 0 to 200°C.

Further, for curing the curable resin composition, curing is caused by UV irradiation for polymerizing the reaction product (A) and the acrylic monomer (B). For this reason, the curable resin composition may contain therein a photopolymerization initiator. Specific examples of the photopolymerization initiator may include: acetophenone type compounds such as acetophenone, chloroacetophenone, diethoxyacetophenone, hydroxyacetophenone, and α-aminoacetophenone; benzoin type compounds such as benzoin, benzoin methyl ether, benzoin ethyl ether, benzoin isopropyl ether, benzoin isobutyl ether, and benzyldimethyl ketal; benzophenone type compounds such as benzophenone, benzoylbenzoic acid, benzoyl methyl benzoate, 4-phenyl benzophenone, hydroxy benzophenone, hydroxy-propyl benzophenone, acrylated benzophenone, Michler's ketone, and 2-hydroxy-2-methylpropiophenone; thioxanthones such as thioxanthone, chlorothioxanthone, methyl thioxanthone, diethyl thioxanthone, and dimethyl thioxanthone; and as other compounds, benzyl, α-acyloxime ester, acyl phosphine oxide, glyoxy ester, 3-ketocumarine, 2-ethyl anthraquinone, camphorquinone, and anthraquinone.

Further, if required, known photoinitiator aids such as amines, sulfones, and sulfines may be added.

The curable resin composition (IX) does not contain an organic solvent not having a radical reactive group and a fluorine type solvent. This is preferable in that the step of removing the solvent after curing the curable resin composition is unnecessary, and in that there are no adverse effects such as reduction of the heat resistance, reduction of the strength, and cloudiness due to the residual solvents. Further, for the curable resin compositions (IX), as with the curable resin compositions (VIII), the curing catalysts exemplified previously can be used.

Further, according to the intended use, to the weather resistant organic material, an organic solvent can also be added.

Examples of the organic solvent may include: hydrocarbon type solvents such as xylene, toluene, Solvesso 100, Solvesso 150, and hexane; ester type solvents such as methyl acetate, ethyl acetate, butyl acetate, acetic acid ethylene glycol monomethyl ether, acetic acid ethylene glycol monoethyl ether, acetic acid ethylene glycol monobutyl ether, acetic acid diethylene glycol monomethyl ether, acetic acid diethylene glycol monoethyl ether, acetic acid diethylene glycol monobutyl ether, acetic acid ethylene glycol, and acetic acid diethylene glycol; ether type solvents such as dimethyl ether, diethyl ether, dibutyl ether, ethylene glycol monomethyl ether, ethylene glycol monoethyl ether, ethylene glycol monobutyl ether, ethylene glycol dimethyl ether, ethylene glycol diethyl ether, ethylene glycol dibutyl ether, diethylene glycol monomethyl ether, diethylene glycol monoethyl ether, diethylene glycol monobutyl ether, diethylene glycol dimethyl ether, diethylene glycol diethyl ether, diethylene glycol dibutyl ether, and tetrahydrofuran; ketone type solvents such as methyl ethyl ketone, methyl isobutyl ketone, and acetone; amide type solvents such as N,N-dimethylacetamide, N-methyl acetamide, acetamide, N,N-dimethylformamide, N,N-diethyl formamide, and N-methyl formamide; sulfonic acid ester type solvents such as dimethyl sulfoxide; and alcohol type solvents such as methanol, ethanol, isopropanol, butanol, ethylene glycol, diethylene glycol, polyethylene glycol (degree of polymerization 3 to 100), $CF_3CH_2OH$, $F(CF_2)_2CH_2OH$, $(CF_3)_2CHOH$, $F(CF_2)_3CH_2OH$, $F(CF_2)_4C_2H_5OH$, $H(CF_2)_2CH_2OH$, $H(CF_2)_3CH_2OH$, and $H(CF_2)_4CH_2OH$. From the viewpoints of the compatibility, the coating film outward appearance, and the storage stability, preferred are alcohol type solvents such as lower alcohols, and lower fluorinated alcohols.

As the mixing ratio of the weather resistant organic material and an alcohol type solvent, alcohol is in a ratio of 1 to 50 parts by mass per 100 parts by mass of the weather resistant organic material. From the viewpoints of the curability and the coating film outward appearance, the ratio is further preferably 1 to 25 parts by mass.

Further, when the curing agent has a high reactivity with alcohols as ordinary temperature-curable type isocyanates, the ratio is further preferably 1 to 15 parts by mass, and the alcohols are also preferably secondary or tertiary alcohols.

To the hydrophilization paint, further, an UV absorber, a silane coupling agent, and/or a hydrophilization promoter, and the like can be added.

When an UV absorber is added thereto, to the coating film, actions of improving the underlayer protecting property and the weather resistance are imparted. As specific examples thereof, for example, benzophenone type and benzotriazole type UV absorbers, and cyano acrylate type UV absorbers are preferable. Out of these, effective are, in the benzophenone type, 2,2'-dihydroxy-4,4'-dimethoxy benzophenone, 2,2'-dihydroxy-4-methoxybenzophenone and 2,2',4,4'-tetrahydroxy benzophenone; and, in benzotriazole type, 2-(2'-hydroxy-5'-methylphenyl)benzotriazole, 2-(2'-hydroxy-5'-methylphenyl)-5,6-dichlorobenzotriazole), 2-(2'-hydroxy-5'-tert-butylphenyl)benzotriazole, 2-(2'-hydroxy-3',5'-di-tert-butylphenyl)-5-chloro-benzotria zole, 2-(2'-hydroxy-5'-phenyl phenyl)-5-chlorobenzotriazole, 2-(2'-hydroxy-3'-tertbutylphenyl)-5-chlorobenzotriazole, 2-(2'-hydroxy-3',5'-ditertbutylphenyl)benzotriazole, and 2-(2'-hydroxy-5'-tertoctyl phenyl)benzotriazole.

As cyano acrylate type UV absorbers, for example, 2-ethylhexyl 2-cyano-3,3-diphenyl acrylate, and ethyl 2-cyano-3,3-diphenyl acrylate can be effectively used.

Particularly preferable UV absorbers are those of the type represented by the following formula:

[CHEMICAL 41]

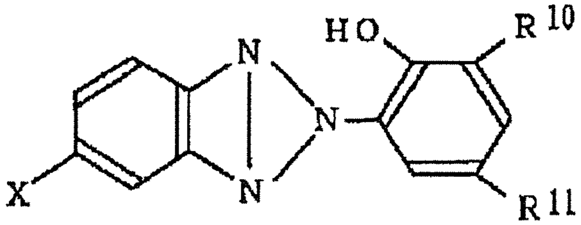

(where in the formula, $R^{10}$ and $R^{11}$ are the same or different, and each represents a hydrogen atom, a lower alkyl group, especially, a branched chain lower alkyl group, or an aryl group, particularly, a phenyl group, X is a hydrogen atom or a halogen atom, particularly, a chlorine atom). Further, cyano acrylate type UV absorbers are less likely to be affected by hydrolysis, and hence are in particular preferable.

The silane coupling agent imparts the recoating adhesion to the coating film. Specific examples thereof may include: as the silane coupling agents, methyl trimethoxysilane, ethyl triethoxysilane, dimethyl dimethoxysilane, trimethyl methoxysilane, vinyl trimethoxysilane, 3-(glycidyloxy)propyl trimethoxysilane, N-(2-aminoethyl)-3-aminopropyl trimethoxysilane, 3-aminopropyl trimethoxysilane, 3-aminopropyl triethoxysilane, 3-mercaptopropyl trimethoxysilane, 3-trimethoxysilylpropyl isocyanate, 3-triethoxysilylpropyl isocyanate, and methyl tris(ethyl methyl ketoxime)silane. Those containing an alkyl ketoxime group, or an isocyanate group are preferable. Particularly, from the viewpoint that the recoatability is excellent, a silane coupling agent having an isocyanate group or an epoxy group is preferable.

By adding a hydrophilization promoter, in the present invention, the hydrolysis of an organometallic compound having a high hydrophilization capacity is aided, and the hydrophilization of the coating film surface is promoted. Further, when the paint resin in the organic material is of a curable type, it contributes to promotion of curing of the coating film. Specific examples thereof may include those exemplified for the curing catalyst. From the viewpoint of hydrophilization, organotin compounds and aluminum chelate compounds are preferable.

Other than these, to the weather resistant organic material, there can also be added additives such as thickener, levelling agent, anti-foaming agent, film-forming aid, HALS, matting agent, filler, colloidal silica, fungicide, anti-skinning agent, antioxidant, flame retarder, dripping inhibitor, antistatic agent, rust inhibitor, and water-soluble resin (such as polyvinyl alcohol or polyethylene oxide).

As a method for forming a film made of an organic material, a proper known method suited to the intended use can be adopted. For example, when the film thickness is required to be controlled, there can be adopted a roll coating method, a gravure coating method, a microgravure coating method, a flow coating method, a bar coating method, a spray coating method, a die coating method, a spin coating method, a dip coating method, or the like.

For the curing method, the optimum one for the material is selected. Generally, there is used either of a heat imprint method or a light imprint method. With the heat imprint method, a thermoplastic material is used, and is brought into close contact with a mold at high temperatures. Then, the temperature is reduced to perform mold release. In light imprint, a photo-curable resin or sol/gel material, or the like is used, and the material is poured into the mold. Then, mainly, an ultraviolet ray is applied thereto, thereby to cure the material. Then, mold release is performed. For mold release, as a mold release agent, conventionally known mold release agents such as OPTOOL DSX (trade name, manufactured by Daikin Industries, Ltd.) and DURASURF HD-1100 and 2100 series (trade name, manufactured by HARVES Co., Ltd.) may be applied and used.

The light-concentrating film preferably concentrates an average of 80% or more of light incident at an angle of 0 to 89° with respect to the direction of the normal to the light-concentrating film. With a planar film using a conventional computer generated hologram, only a light-concentrating film with a pattern having a binary gradation can be manufactured. For this reason, the light incident at a shallow angle with respect to the in-plane direction of the light-concentrating film cannot be concentrated sufficiently. The light-concentrating film of the present invention has a multilevel gradation pattern. Accordingly, even for light incident at an angle of 0 to 89°, the light concentration rate can be set at an average of 80% or more. The light incident at an angle of 0 to 89° with respect to the direction of the normal to the light-concentrating film preferably includes light incident upon a region having multilevel gradation pattern. The light concentration rate can be measured with a method using a light-receptive element, but may be calculated by simulation using optical design software ZEMAX (manufactured by T. E. M. Incorporated).

The thickness of the light-concentrating film may be appropriately set according to the intended application for use, and for example, the thickness is preferably 0. 03 to 20 mm. More preferably, it is 0.1 to 5 mm. When the light-concentrating film has a thickness within the range, it can be preferably used as a light-concentrating film for solar cell. The film thickness is determined by measuring the maximum thickness of the light-concentrating film using a thickness meter.

For the light-concentrating film, the yellow index ΔYI value is preferably 20 or less. More preferably, it is 10 or less, and further preferably 5 or less.

The yellow index ΔYI value is a value obtained by measuring the light-concentrating film subjected to a pressure cooker test under a 105°C and 100%RH atmosphere for 200 hours by means of a color difference meter.

The light-concentrating film of the present invention can concentrate even light incident at a shallow angle with respect to the in-plane direction of the film with high efficiency. For this reason, when the light-concentrating film is used for a solar cell module, without being formed into a tracking type solar cell which changes the orientation of the solar cell according to respective orientations of the sun in morning, day, and night, the solar cell can implement a high-efficiency generating efficiency in a non-tracking manner (omnidirectional light concentration). This enables reduction of the cost, simplification of facilities, and the like as compared with conventional solar cells.

Preferable examples of articles of the light-concentrating film of the present invention may include, other than solar cell, those for the purpose of focusing for illumination in buildings, commercial facilities, ordinary households, and the like, microfluidic devices, optical devices, recording media, and LED diffusion plates. Examples of the microfluidic devices may include a microreactor chip and a micro TAS.

Examples of the optical devices may include microlenses and optical elements. As the articles of the present invention, mention may be further made of biochips, antireflection filters, catalyst carriers, and the like.

The light-concentrating film of the present invention may be produced by a production method including a step of calculating the multilevel gradation pattern by discrete Fourier transform; and a step of forming a light-concentrating film having the multilevel gradation pattern. As described above, by discrete Fourier transform, the operation speed can be improved. For this reason, the produced light-concentrating film has a high quality, and can form a large-area multilevel gradation pattern. The step of calculating the multilevel gradation pattern can be performed by using the Fourier transform device.

As one of preferred aspects, the production method preferably includes steps of a step of forming a mold having the reversal pattern of the multilevel gradation pattern calculated by discrete Fourier transform; and a step of bringing the mold into contact with a film made of an organic material, and forming a light-concentrating film having a multilevel gradation pattern, or a step of forming a light-concentrating film having a multilevel gradation pattern by injection molding using the mold as a die or by a molding method using heat, room temperature, and UV imprinting.

The mold can be manufactured using a photolithography method for performing exposure by irradiation while changing the intensity from place to place using a light source such as an electron beam (EB), an argon laser (363 nm light source wavelength), a blue semiconductor laser (405 nm light source wavelength), a krypton laser (413 nm light source wavelength), or a helium-cadmium laser (442 nm light source wavelength). When a mold is manufactured, development of a resist after exposure results in the formation of a resist with concavo-convex having a multilevel gradation according to the exposure light source intensity of electron beam or the like. This is subjected to ashing (etching) with a plasma on the surface of the resist, or a metal film is evaporated directly on the surface of the developed resist, thereby performing electroforming. Then, the substrate and the resist are released, resulting in a metal mold. The materials for the mold have no particular restriction. However, for example, preferred are metal materials such as nickel and silicon, quartz, and glass. Incidentally, the "reversal pattern of the multilevel gradation pattern" is a pattern having an concavo-convex shape reverse to that of the multilevel gradation pattern, and is the one capable of forming a multilevel gradation pattern when the reversal pattern is brought into contact with the objective organic material.

As the methods for bringing the mold into contact with an organic material, mention may be made of a method in which the reversal pattern-formed side of the mold is brought into contact with a film made of an organic material, thereby transfer the multilevel gradation pattern; a method of performing injection molding with the mold as a die; and other methods.

It is also one of preferable modes that the method for producing a light-concentrating film includes a step of applying a laser to a film made of an organic material, and forming a light-concentrating film having a multilevel gradation pattern. In this case, on the film made of an organic material, the multilevel gradation pattern resulting from calculation by the discrete Fourier transform is directly drawn with a laser, thereby to form a light-concentrating film having a multilevel gradation pattern. This is distinguished from the hologram formed by the laser interference fixing. As the laser used for the case where the film made of an organic material is irradiated with a laser, a laser used in the photolithography method can be used.

The light-concentrating film of the present invention can be used in various optical fields. For example, the light concentrated through the light-concentrating film can be used for solar cell, illumination in buildings, commercial facilities, and ordinary households, and the like. The illumination is also effective as a substitute for, for example, illumination (such as LED) at plant factories, or TV backlight.

Further, the light-concentrating film of the present invention can also diffuse the incident light, and is also effective as a substitute for a diffusion plate for diffusing light emitted from a LED light source for use in, for example, a LED television set.

Another aspect of the present invention is a solar cell module including the light-concentrating film of the present

invention. The solar cell module with the light-concentrating film can concentrate light in a wide angular range and produce electric power with high efficiency even when used in a non-tracking type solar cell. The solar cell module can be used in both tracking type and non-tracking type solar cells, but is especially suitably used in non-tracking type solar cells because it can concentrate light in a wide angular range. The solar cell module may be a flexible solar cell.

The solar cell module of the present invention is preferably installed such that a smooth surface of the light-concentrating film is exposed to the air. The light-concentrating film of the present invention eliminates the need of making light incident upon a surface having a repeating structure of fine concavo-convex. Even when the solar cell module is installed such that a smooth surface of the light-concentrating film is exposed to the air, a high focusing efficiency can be obtained. Also, since a smooth surface of the light-concentrating film is exposed to the air, a high antifouling property can be obtained.

Another aspect of the present invention is a solar cell module including a solar battery cell, a sealing material layer that seals the solar battery cell therein, and a light-concentrating film, the light-concentrating layer being on either or both sides of the sealing material layer. Fig. 8 is a cross-sectional schematic view illustrating one embodiment of the solar cell module of the present invention. The solar cell module 800 of the present embodiment includes a solar battery cell 81, a sealing material layer 82 that seals the solar battery cell 81 therein, and a light-concentrating film 83 that is on both sides of the sealing material layer 82.

Another aspect of the present invention is a solar cell module including a solar battery cell, a sealing material layer that seals the solar battery cell therein, a translucent layer, and a light-concentrating film, the translucent layer being on either or both sides of the sealing material layer, and the light-concentrating layer being on the translucent layer. Fig. 9 is a cross-sectional schematic view illustrating one embodiment of the solar cell module of the present invention. The solar cell module 900 of the present embodiment includes a solar battery cell 81, a sealing material layer 82 that seals the solar battery cell 81 therein, a translucent layer 84, and a light-concentrating film 83, the translucent layer 84 being on both sides of the sealing material layer 82, and the light-concentrating layer 83 being on the translucent layer 84. When the translucent layer is disposed on both sides of the sealing material layer, the light-concentrating film may be disposed on either one of the translucent layers.

Any solar battery cell is acceptable so long as it can produce electric power by receiving light. Examples thereof may include those obtained by pn-joining n type semiconductors and p type semiconductors. Usable n type semiconductors and p type semiconductors have no particular restriction. The materials commonly used for a solar cell can be used. Examples thereof may include IV group semiconductors such as Si and Ge, III-V group compound semiconductors such as GaAs, InP, and AlGaAs, II-VI group compound semiconductors such as CdS, CdTe, and $Cu_2S$, I-III-VI group compound semiconductors such as $CuInSe_2$, $CuInS_2$, and Cu(In, Ga)$Se_2$, organic semiconductors such as phthalocyanine and polyacetylene, three-junction laminations such as InGaP/(In)GaAs/Ge, and semiconductors such as CdTe. Further, solar battery cells can be used irrespective of the crystal type or the amorphous type. Further, even when the cell is a quantum effect type or a dye sensitizing type solar cell, light concentration in a wide angular range becomes possible. Whether the cell is a solar cell of a tracking type or non-tracking type solar cell, it can produce electric power at a high efficiency. In general, the solar cell includes a wire coupled to the solar battery cell.

The solar cell module of the present invention may include a solar battery cell and a focusing element having a structure in which a Fresnel lens and a light-concentrating film are bonded using an adhesive layer, or only light-concentrating films are bonded to each other using an adhesive layer. In a solar cell module with a focusing element including a Fresnel lens and a light-concentrating film, light in-plane focused through the light-concentrating film is further focused to one point through the Fresnel lens, and the solar battery cell receives the focused light. Thus, formation of a distance between a focusing element and a solar battery cell enables light concentration, leading to a size reduction of the solar battery cell, which enables reduction in cost.

The light-concentrating film of the present invention is usable for focusing elements. Since the light-concentrating film enables light concentration in a wide angular range, a focusing elements with the film can have a significantly improved in-plane focusing efficiency. It is essential only that the focusing element of the present invention includes at least the light-concentrating film. The shape thereof may be a flat shape, a domical (semi-spherical shape), or the like. The focusing element preferably includes a light-concentrating film and a lens. As the lenses, mention may be made of, but is not particularly limited to, a prism lens, a fly-eye lens, a lens array, a linear Fresnel lens, a Fresnel lens described later, a lenticular lens, and the like.

The lens is preferably made of a fluororesin. The lens being a fluororesin improves the durability as the focusing element, and hence the lens becomes a focusing element which can be preferably used for a solar cell or the like. As fluororesins used for the lens, mention may be preferably made of the fluororesins exemplified for the light-concentrating film. Preferable fluororesin is at least one fluororesin selected from the group consisting of ETFE, PCTFE, EFEP, FEP, and PVdF.

The focusing element preferably includes at least one selected from the group consisting of Fresnel lenses and lenticular lenses. The Fresnel lenses and the lenticular lenses may be those generally referred to as Fresnel lenses or lenticular lens, and have no particular restriction. As a result, the light in-plane focused in all directions through the

light-concentrating film can be further focused to one point through a Fresnel lens or a lenticular lens. Although the light-concentrating film can perform omnidirectional light concentration when used singly, if the light-concentrating film and a Fresnel lens or a lenticular lens are used in combination, the focusing distance can be controlled and the light density can be enhanced, whereby the dramatic improvement of the generating efficiency is facilitated.

Incidentally, by control of the results of the computer generated hologram, the light-concentrating film of the present invention focuses sunlight within a plane, and in addition, is more uniform and aplanatic as compared with a conventional Fresnel lens and lenticular lens, and can also express a high precision one-point focusing function.

Then, the present invention will be described by way of examples and comparative examples. However, the present invention is not limited to only such examples.

Example 1

(1) Calculation of multilevel gradation pattern

Interference fringes of a hologram to be obtained were calculated by steps of: calculating a diffraction of object light and a complex amplitude of reference light; making the object light interfere with the reference light; and forming a diffraction pattern of fine concavo-convex of a computer generated hologram. A computer generated hologram multilevel gradation pattern was formed by outputting the interference fringes in BMP format with 256 gray scales and giving eight levels of gradation to a resist for light exposure in the thickness direction, based on the output data. The multilevel gradation pattern was calculated using discrete Fourier transform under the conditions such that the light transmittance of an organic material of a light-concentrating film was 95%, that the refractive index was 1. 40, that the film thickness (maximum film thickness) of the light-concentrating film was 100 μm, and that the light-concentrating film was in the shape of a circle with a diameter of 160 mmϕ.

The program may include a computer generated hologram pattern calculated supposing that the obj ect is a diffuser panel to cope with scattering light in a cloudy sky.

The number of the pixels was 2000 × 2000, and the sampling frequency was 1000 dots/mm. Accordingly, one hologram pattern was a concentric circle pattern composed of 34 rings fit in 4 mm square. The hologram patterns were written using a lithography device such that they were arranged in 6 by 6 arrays to form a computer generated hologram multilevel gradation pattern of 24 mm square (Fig. 10).

Here, the multilevel gradation pattern is preferably formed using a program for multilevel gradation with up to 32 levels of gradation written in MATLAB language. Each data of the phase diffraction grating pattern represented in gray scales was generated using a MATLAB program. This data was, using a PC for conversion, confirmed to be convertible into a LIC file for a laser direct writing device. Thereafter, the LIC file was transferred to a laser direct writing device, and after checking if writing operation is possible, the multilevel gradation pattern was formed.

(2) Production of light-concentrating film

As an organic material film for forming a multilevel gradation pattern, an ETFE film was used.

A mold having a reversal pattern of the multilevel gradation pattern of the light-concentrating film to be obtained calculated by discrete Fourier transform was produced using a laser direct photolithography method. First, a resist (AZ1350: manufactured by Clariant) applied on a glass substrate to have a thickness of 1.4 μm was exposed and irradiated with a helium-cadnium laser (g-line: a light source of wavelength 442 nm) while changing the intensity from one site to another.

Thereafter, the resist was developed using a developer (AZ-Developer: manufactured by Clariant) under the conditions of a room temperature of 20°C and a developing time of one minute with oscillation. Thereby, a resist film with concavo-convex having a multilevel gradation pattern corresponding to a light source intensity of the irradiated light was obtained. Nickel was directly metal deposited to this resist film, and a mold formed by the metal deposition was released from the resist film. The resultant mold has eight levels of gradation, a height (H) of concavo-convex of 1 μm, a frequency (P) of concavo-convex of 30 μm at the outermost periphery of concentric circles, 78 μm at the middle of the concentric circles, and 185 μm at the center portion of the concentric circles.

In the resultant mold, the height (D) of one step was 125 nm, and the width (L) of one step has a rectangular concavo-convex shape, and was 3.75 μm on average at the outermost periphery of the concentric circles, 9.75 μm at the middle of the concentric circles, and 23.1 μm at the center of the concentric circles. The width (L) changed non-lineally and gradationally (Fig. 11).

Here, the width (W) of concavo-convex was equal to the frequency (P) of concavo-convex. The relation between the frequency (P) of the concavo-convex and the width (W) of concavo-convex satisfied P-W = 0.

Then, against an ETFE film which is an organic material (Neoflon film ETFE manufactured by Daikin Industries, Ltd., thermal deformation temperature 104°C, film thickness 100 μm), using a nanoimprinting device NANOIMPRINTER

NM-0501 (manufactured by MEISYO KIKO Co., Ltd.), the metal rectangular mold including eight levels of gradation is pressed at 250°C under a pressure of 10 MPa for 5 minutes, thereby to form a light-concentrating film having a multilevel gradation pattern.

The resultant light-concentrating film has, in the region having a multilevel gradation pattern, eight levels of gradation, a height (H) of concavo-convex of 1 μm, a frequency (P) of concavo-convex of 30 μm at the outermost periphery of the concentric circles, 78 μm at the middle of the concentric circles, and 185 μm at the center portion of the concentric circles, and a height (D) of one step of 125 nm. The width (L) of one step has a rectangular concavo-convex shape, and was 3.75 μm on average at the outermost periphery of the concentric circles, 9.75 μm at the middle of the concentric circles, and 23.1 μm at the center of the concentric circles. The width (L) changed non-lineally and gradationally.

After forming of the multilevel gradation pattern, the cross-section shape of the pattern formed on the film surface was observed using a non-contact surface shape measurement instrument with laser probe (manufactured by Mitaka Kohki.Co., Ltd). The result showed that the shape of the mold was precisely transferred to the resultant light-concentrating film (Fig. 12).

(Continuous production method of light-concentrating film)

While continuously extruding a fluororesin film 130 including an ETFE film or PCTFE (trade name: Neoflon ETFE or PCTFE, manufactured by Daikin Industries, Ltd.) from a film roll 131 as shown in Fig. 13, using an imprinting device 133, a mold 132 having a reversal pattern of the multilevel gradation pattern is brought into contact with the fluororesin film 130. Thus, the multilevel gradation pattern is transferred onto the fluororesin film 130. Then, by a plurality of rolls 134, laminating is performed. Using a cutter 135, the film 130 is cut into a desired size. Thus, it is also possible to form a light-concentrating film capable of omnidirectional light concentration.

(Method for producing a solar cell module with light concentrating properties)

The light-concentrating film produced by the method described above was bonded using a highly transparent adhesive sheet using an acrylic adhesive (trade name: highly transparent adhesive film CEF08A07L5, manufactured by 3M Co.), an ionomer, a silicone resin, a thermoplastic resin, and further a thermoplastic resin (EVA) containing a heat curing agent to provide a focusing element. The focusing elements were laid on the entire surface of a solar cell module to provide a solar cell module with light concentrating properties.

Example 2

A light-concentrating film having a multilevel gradation pattern was prepared in the same manner as in Example 1, except that, during the use of a nano imprinting device (NANOIMPRINTER NM-0501, manufactured by Meisyo kiko Co., Ltd.), an UV coating layer (PAK-01: manufactured by Toyo Gosei Co., Ltd.) having a thickness of 10 μm was formed on a surface of a transfer base, and that a mold was pressed against the coating layer at a pressure of 1 MPa and room temperature for one minute with irradiation of ultra violet light of 2000 mJ.

Comparative Example 1

The same solar cell module as that used in Example 1 was prepared. This solar cell module was different from the solar cell module of Example 1 with light-concentrating properties in that the light-concentrating film was not installed.

Focusing efficiencies of the solar cell modules of Example 1 and Comparative Example 1 were measured using a solar simulator (1.5 G, manufactured by Wacom Electric Co., Ltd.). Table 1 shows the results.

In comparison with the solar cell module of Comparative Example 1, which is not provided with a light-concentrating film, the solar cell module obtained in Example 1, which has a light-concentrating film having a multilevel gradation pattern, showed an increase of 99% in power generation at an incident angle of 5 degrees, and also showed an average increase of about 5% in light-focusing power generation efficiency, represented as the maximum power output Pmax. In the solar cell module of Comparative Example 1, the focusing efficiency significantly decreases as the incidence angle lowered.

[Table 1]

| Light incident angle (degree) | Pmax according to degrees | | Increase rate according to degrees (%) |
|---|---|---|---|
| | Comparative Example 1(W) | Example 1 (W) | |
| 90 | 0.611 | 0.636 | 4.10 |
| 85 | 0.620 | 0.644 | 3.78 |
| 80 | 0.616 | 0.641 | 4.03 |
| 75 | 0.608 | 0.631 | 3.79 |
| 70 | 0.572 | 0.594 | 3.85 |
| 65 | 0.545 | 0.568 | 4.16 |
| 60 | 0.524 | 0.541 | 3.29 |
| 55 | 0.499 | 0.520 | 4.23 |
| 50 | 0.463 | 0.486 | 4.78 |
| 45 | 0.432 | 0.451 | 4.24 |
| 40 | 0.383 | 0.407 | 6.29 |
| 35 | 0.330 | 0.350 | 6.02 |
| 30 | 0.288 | 0.313 | 9.02 |
| 25 | 0.234 | 0.254 | 8.61 |
| 20 | 0.182 | 0.193 | 5.82 |
| 15 | 0.110 | 0.123 | 11.71 |
| 10 | 0.060 | 0.075 | 24.61 |
| 5 | 0.013 | 0.027 | 99.34 |
| Total | (a) 7.090 | (b) 7.454 | - |
| Increase rate of maximum output Pmax (%) | (((b)-(a))/(a))*100=5.1 | | |

INDUSTRIAL APPLICABILITY

The light-concentrating film of the present invention has the foregoing configuration, and hence, can be used in wide-ranging fields such as a focusing element for solar cells and illumination substitutes by solar lighting.

REFERENCE SIGNS LIST

10, 31, 41, 51, 61 concavo-convex
11, 32, 42, 62 Stepped slope
12, 33, Upstanding portion
13, 43, Bottom portion
21 Repeating structure of concavo-convex
300, 400, 500, 600 Light-concentrating film
70 Sampling circuit
71 Phase correction part
$71_0$ to $71_{m-1}$ Phase corrector
72 Fourier transform part
$72_0$ to $72_{m-1}$ FFT computing unit
73 Synthesizer
74 Phase corrector

75 Fouries transform device
81 solar battery cell
82 Sealing material layer
83 Light-concentrating film
84 Translucent layer
800, 900 Solar cell module
131 Film roll
133 Imprinting device
134 Roll
135 Cutter

## Claims

**1.** A light-concentrating film made of an organic material,
the light-concentrating film having a repeating structure of fine concavo-convex on at least one surface, the height (H) of the concavo-convex being 0.1 to 100 μm, and the frequency (P) of the concavo-convex being 0.1 to 500 μm, the concavo-convex having a stepped slope, the height (D) and the width (L) of one step of the stepped slope being larger or smaller toward bottom portions of the concavo-convex, the height (D) of the one step of the stepped slope being 0.01 to 100 μm, the width (L) of one step of the stepped slope being 0.01 to 100 μm.

**2.** The light-concentrating film according to claim 1, wherein the organic material has a refractive index of 1.30 to 1.65.

**3.** The light-concentrating film according to claim 1 or 2,
wherein the organic material is at least one fluororesin selected from the group consisting of polychlorotrifluoroethylene, ethylene/tetrafluoroethylene copolymers, ethylene/chlorotrifluoroethylene copolymers, chlorotrifluoroethylene/tetrafluoroehtylene copolymers, tetrafluoroethylne/hexafluoropropylene copolymers, tetrafluoroethylene/perfluoro(alkyl vinyl ether) copolymers, and polyvinylidene fluoride.

**4.** The light-concentrating film according to claim 1, 2, or 3,
wherein each of the concavo-convex is a substantially tapered concave or convex.

**5.** The light-concentrating film according to claim 1, 2, or 3,
wherein the repeating structure of concavo-convex includes a plurality of linear concave or linear convex that are arranged in substantially parallel.

**6.** The light-concentrating film according to claim 1, 2, 3, 4, or 5, which is transmissive.

**7.** The light-concentrating film according to claim 1, 2, 3, 4, 5, or 6, which has a repeating structure of fine concavo-convex on one surface, the other surface being smooth.

**8.** The light-concentrating film according to claim 1, 2, 3, 4, 5, or 6, which has a repeating structure of fine concavo-convex on both sides.

**9.** A solar cell module, comprising the light-concentrating film according to claim 1, 2, 3, 4, 5, 6, 7, or 8.

**10.** A solar cell module, comprising the light-concentrating film according to claim 7,
a smooth surface being exposed to the air.

**11.** A solar cell module, comprising:

a solar battery cell,
a sealing material layer that seals the solar battery cell therein, and
the light-concentrating film according to claim 1, 2, 3, 4, 5, 6, 7, or 8,
the light-concentrating film being on either or both sides of the sealing material layer.

**12.** A solar cell module, comprising:

a solar battery cell,
a sealing material layer that seals the solar battery cell therein,
a translucent layer, and
the light-concentrating film according to claim 1, 2, 3, 4, 5, 6, 7, or 8,
the translucent layer being on either or both sides of the sealing material layer, and
the light-concentrating layer being on the translucent layer.

FIG.1

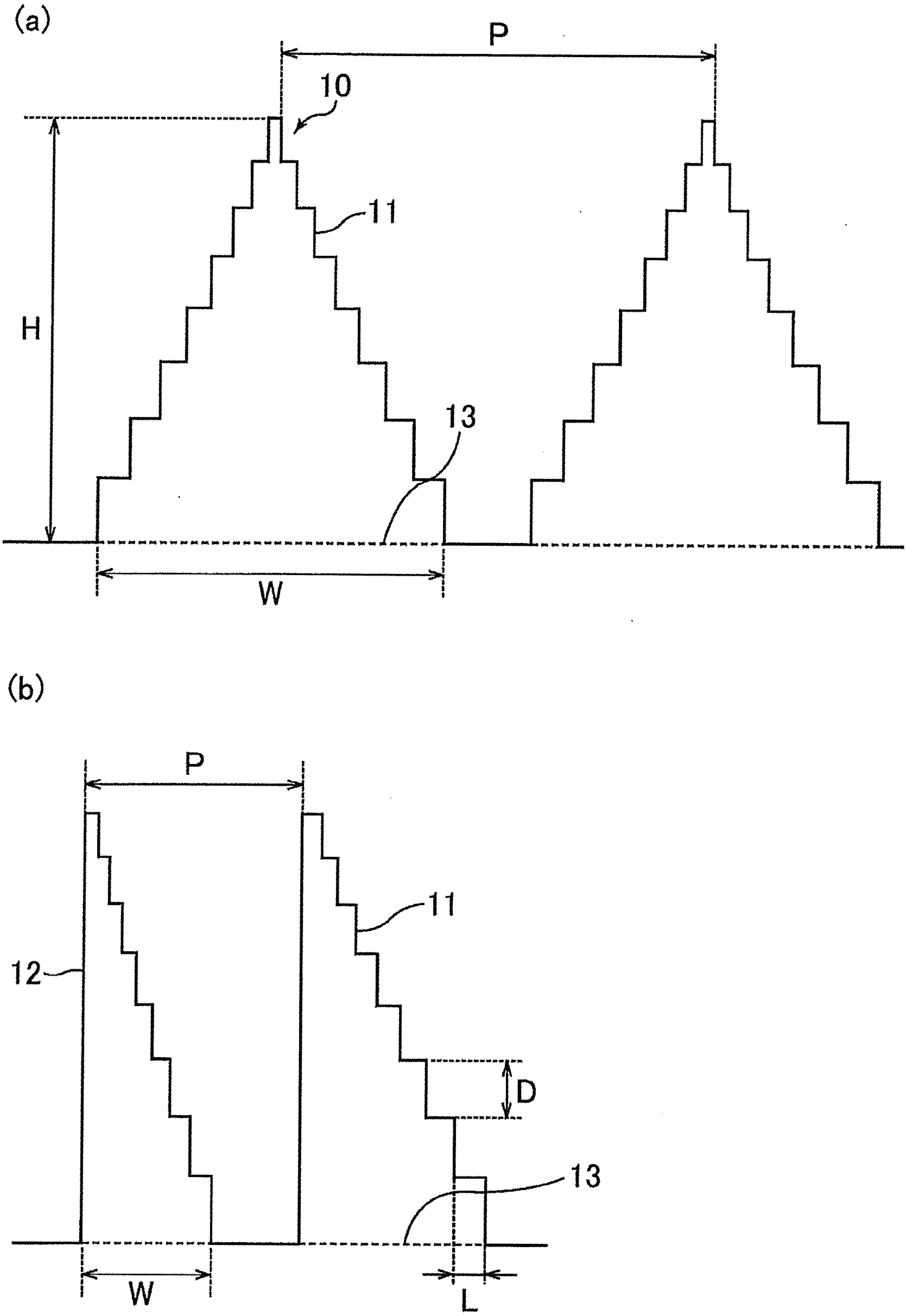

FIG.2

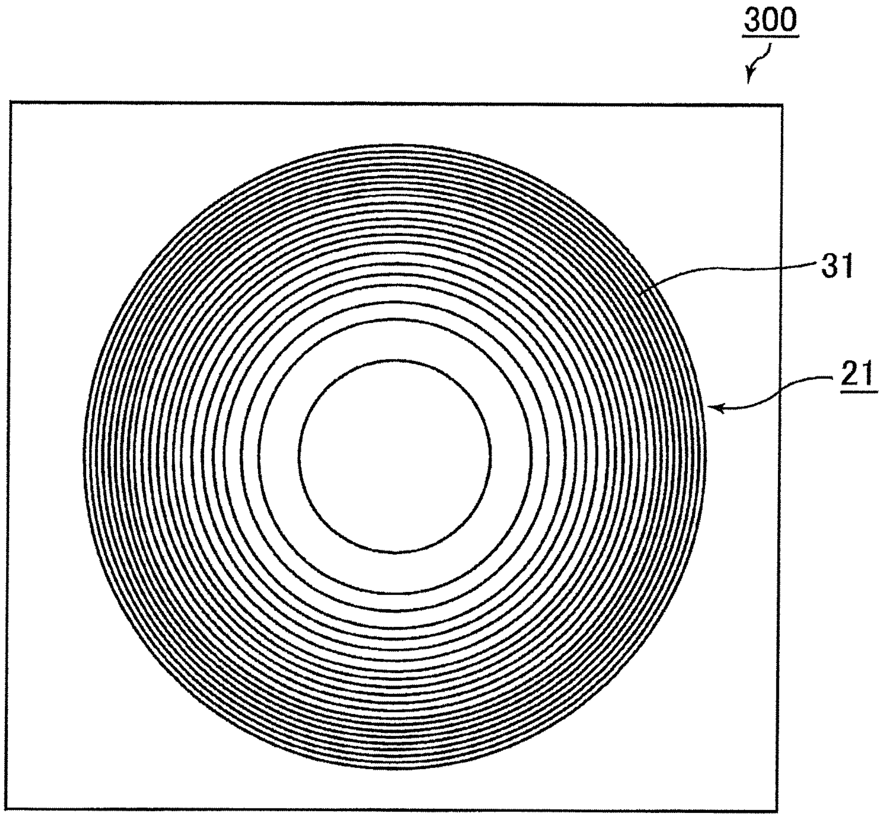


FIG.3

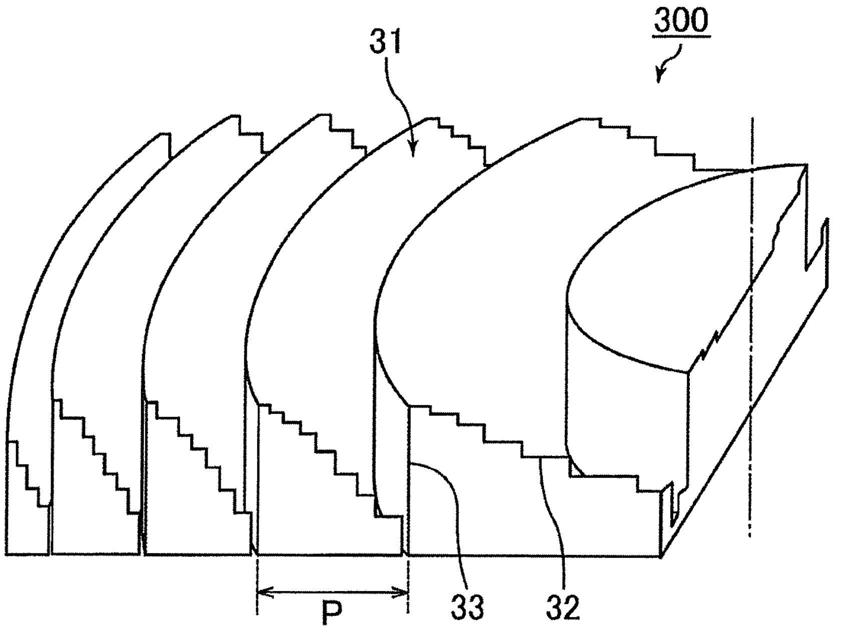

FIG.4

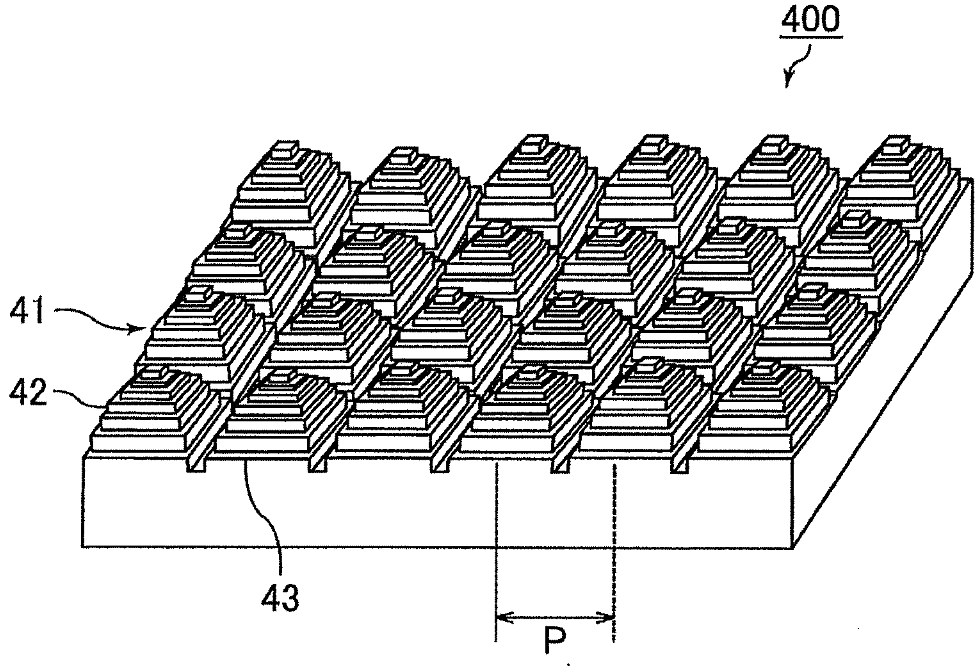


FIG.5

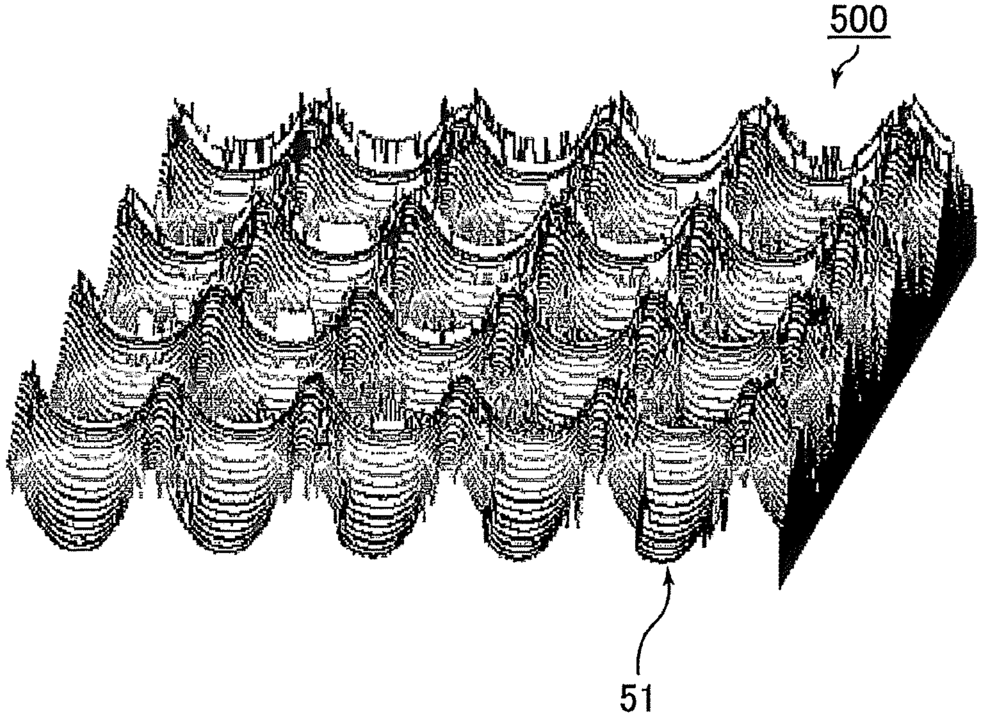

FIG.6

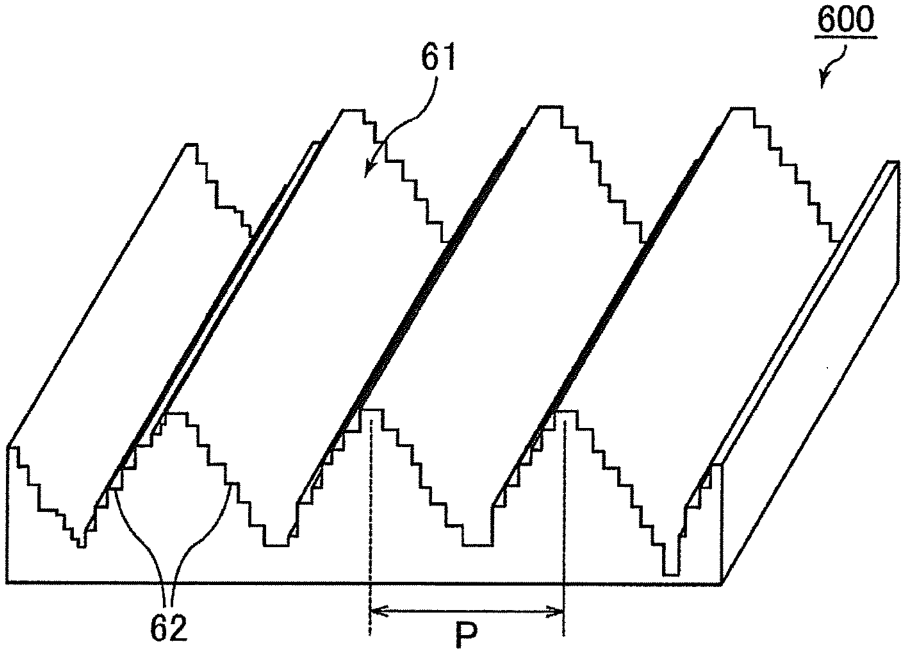

FIG.7

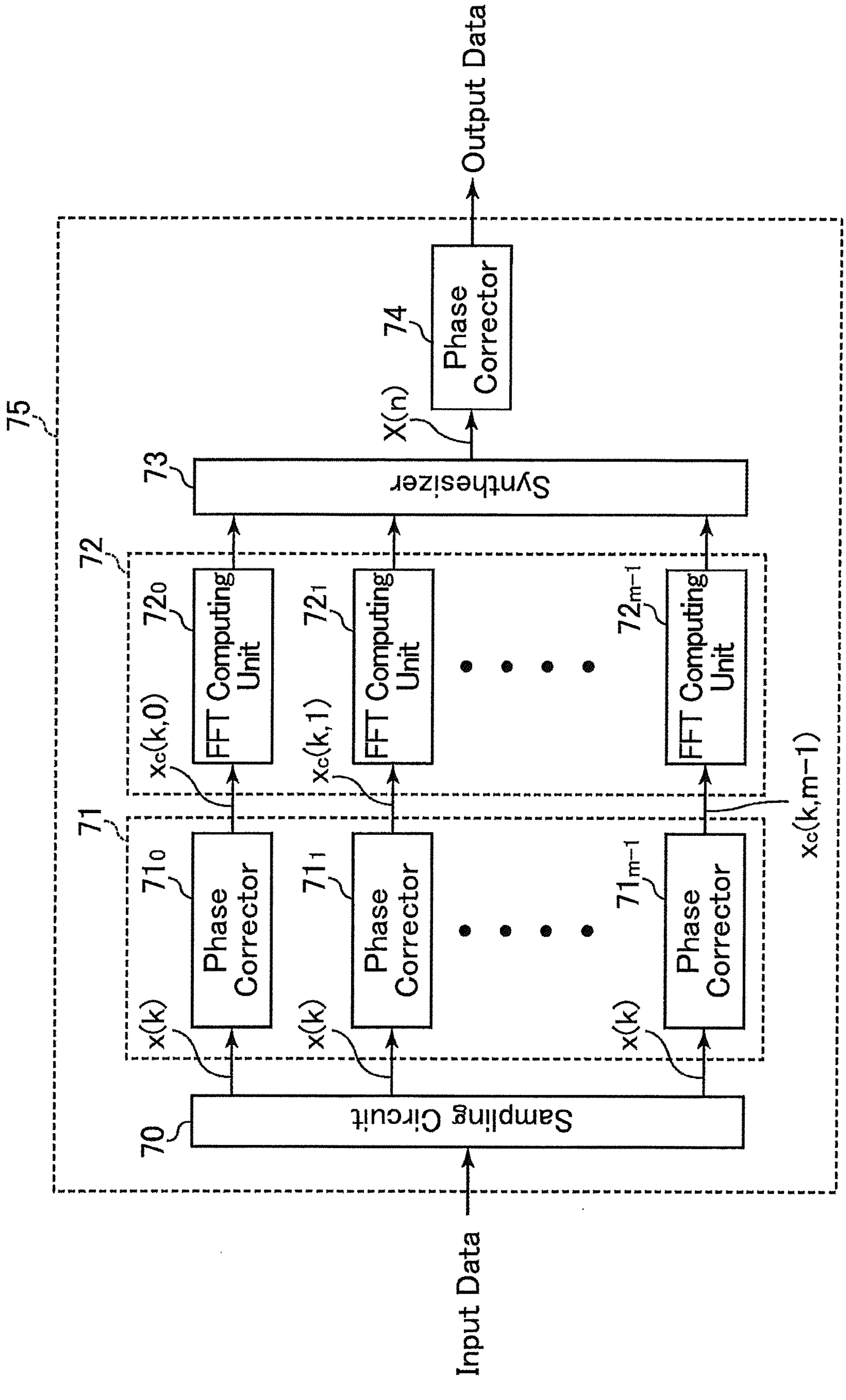
Output Data
75
74
Phase Corrector
X(n)
73
Synthesizer
72
72₀
FFT Computing Unit
72₁
FFT Computing Unit
72m−1
FFT Computing Unit
xc(k,0)
xc(k,1)
xc(k,m−1)
71
71₀
Phase Corrector
71₁
Phase Corrector
71m−1
Phase Corrector
x(k)
x(k)
x(k)
70
Sampling Circuit
Input Data

FIG.8

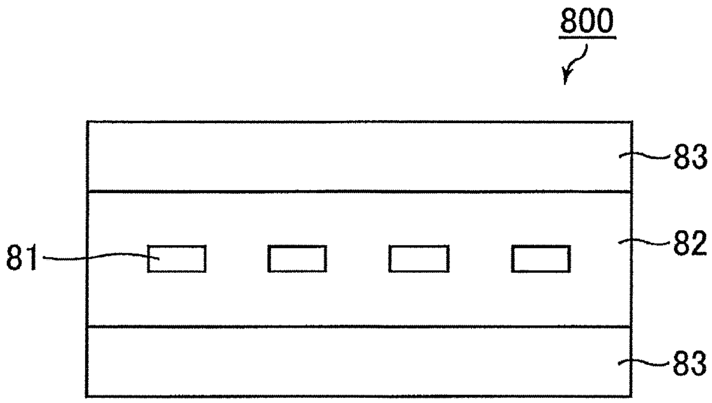


FIG.9

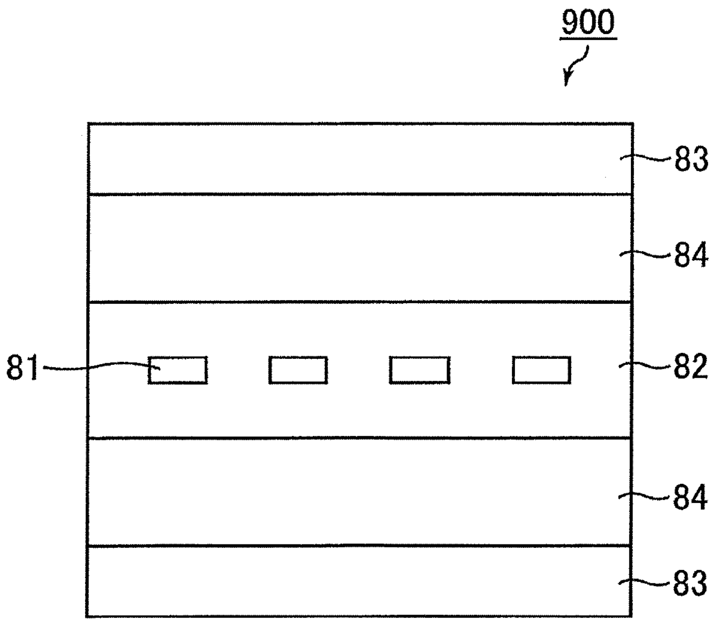


FIG.10

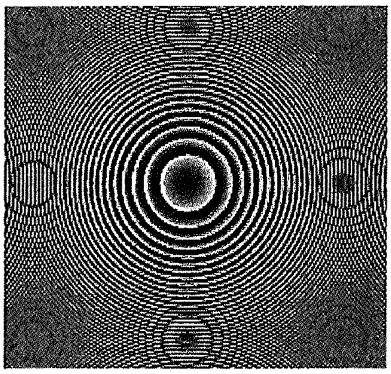

FIG.11

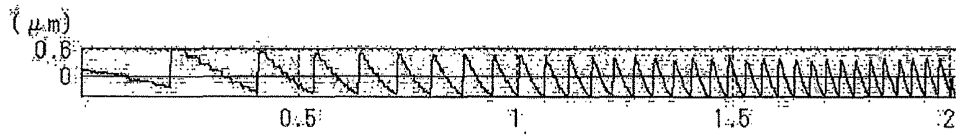


FIG.12

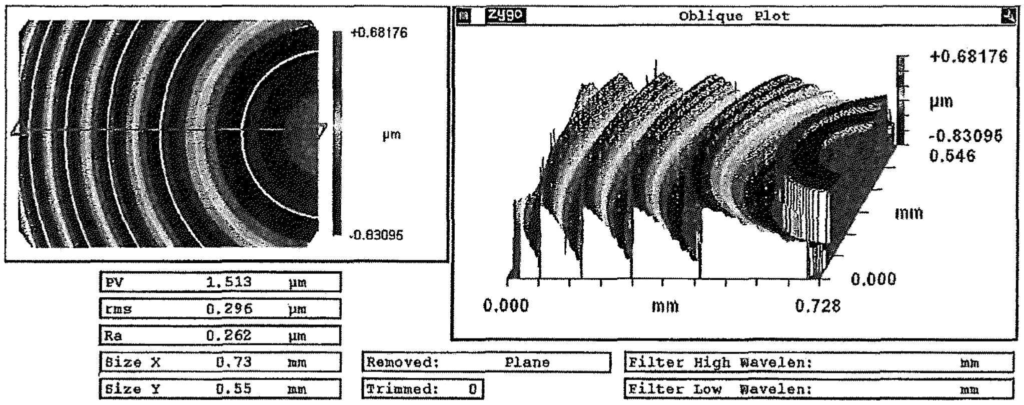


FIG.13

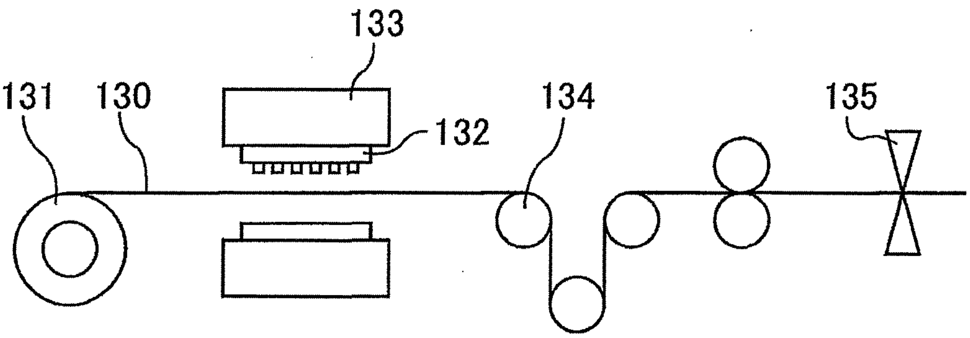

**INTERNATIONAL SEARCH REPORT**

International application No.
PCT/JP2012/056536

A. CLASSIFICATION OF SUBJECT MATTER
*G02B3/08*(2006.01)i, *G02B3/00*(2006.01)i, *H01L31/052*(2006.01)i

According to International Patent Classification (IPC) or to both national classification and IPC

B. FIELDS SEARCHED

Minimum documentation searched (classification system followed by classification symbols)
G02B3/08, G02B3/00, H01L31/052

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2012 |
| Kokai Jitsuyo Shinan Koho | 1971-2012 | Toroku Jitsuyo Shinan Koho | 1994-2012 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2007-310253 A (Dainippon Printing Co., Ltd.), 29 November 2007 (29.11.2007), entire text; all drawings (Family: none) | 1-12 |
| A | WO 2009/075195 A1 (Toyota Motor Corp.), 18 June 2009 (18.06.2009), entire text; all drawings & US 2010/0307565 A1 & EP 2234177 A1 & WO 2009/075195 A1 & CN 101897037 A | 1-12 |

☐ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 12 June, 2012 (12.06.12) | 26 June, 2012 (26.06.12) |

| Name and mailing address of the ISA/ | Authorized officer |
|---|---|
| Japanese Patent Office | |
| Facsimile No. | Telephone No. |

Form PCT/ISA/210 (second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 3687836 B
- JP 2002228819 A
- JP 2004206254 A
- WO 2005100420 A1
- JP S6021686 B
- JP H3121107 A
- JP H4279612 A
- JP H428707 A
- JP H2232221 A
- WO 9711130 A1
- JP S4310363 B
- JP H328206 A
- JP H4189879 A
- JP H2232250 A
- JP H2232251 A
- WO 0218457 A


### Non-patent literature cited in the description


- **GLENN RASENBERG et al.** Holographic planar concentrator increases solar-panel efficiency. *Laser Focus World Japan, Japan,* 2009, vol. 2, 26-28
- *Applied Optics,* 1994, vol. 33, 863-867